# EUROPEAN PATENT APPLICATION

(11) **EP 4 773 138 A1**
(43) Date of publication of application: **08.07.2026**
(21) Application number: 25212115.7
(22) Date of filing: 29.10.2025
(51) Int. Cl.: G11C 5/04, G11C 5/02

(54) **MULTI-CHIP PACKAGE AND MEMORY SYSTEM**

(30) Priority: 02.01.2025 KR 20250000035
(71) Applicant: Samsung Electronics Co., Ltd., Suwon-si, Gyeonggi-do 16677 (KR)
(72) Inventor: KWON, Daehyun, 16677 Suwon-si (KR); KWON, Hyejung, 16677 Suwon-si (KR); PARK, Yongin, 16677 Suwon-si (KR); SONG, Hongjoo, 16677 Suwon-si (KR); SHIN, Changyong, 16677 Suwon-si (KR); CHOI, Jaemin, 16677 Suwon-si (KR); BYUN, Jindo, 16677 Suwon-si (KR)
(74) Representative: Marks & Clerk LLP

(57) **Abstract**

Provided is a multi-chip package including: a printed circuit board (PCB) extending in a first direction and a second direction, wherein the second direction crosses the first direction; and a plurality of memory chips stacked on the PCB in a third direction, wherein the plurality of memory chips are configured to communicate with an external memory controller through a signal transmission line and to share the signal transmission line, wherein the third direction is perpendicular to the first direction and the second direction, wherein each of the plurality of memory chips includes a respective one of a plurality of on-die termination (ODT) circuits coupled to the signal transmission line, and wherein each of the plurality of memory chips is configured to individually set a resistance value of the respective one of the plurality of ODT circuits based on respective position information of the respective memory chip relative to a surface of the PCB.

## Description

### BACKGROUND

The disclosure relates to semiconductor memory devices, and more particularly to multi-chip packages and memory systems.

A plurality of memory chips may be mounted inside a multi-chip package. The plurality of memory chips mounted inside the multi-chip package are normally electrically connected to each other via bonding wires inside the multi-chip package.

The plurality of memory chips may share signal communication lines with a memory controller that controls the multi-chip package and signal integrity of each of the plurality of memory chips may vary based on a position of each of the plurality of memory chips inside the multi-chip package.

### SUMMARY

Provided is a multi-chip package capable of enhancing signal integrity.

Further provided is a memory system including a plurality of memory chips capable of enhancing signal integrity.

According to an aspect of the disclosure, a multi-chip package includes: a printed circuit board (PCB) extending in a first direction and a second direction, wherein the second direction crosses the first direction; and a plurality of memory chips stacked on the PCB in a third direction, wherein the plurality of memory chips are configured to communicate with an external memory controller through a signal transmission line and to share the signal transmission line, wherein the third direction is perpendicular to the first direction and the second direction, wherein each of the plurality of memory chips includes a respective one of a plurality of on-die termination (ODT) circuits coupled to the signal transmission line, and wherein each of the plurality of memory chips is configured to individually set a resistance value of the respective one of the plurality of ODT circuits based on respective position information of the respective memory chip relative to a surface of the PCB.

According to an aspect of the disclosure, a memory system includes: a multi-chip package; and a memory controller configured to control the multi-chip package through a signal transmission line, wherein the multi-chip package includes: a printed circuit board (PCB) extending in a first direction and a second direction, wherein the second direction crosses the first direction; and a plurality of memory chips stacked on the PCB in a third direction, wherein the plurality of memory chips are configured to communicate with the memory controller through the signal transmission line and to share the signal transmission line, wherein the third direction is perpendicular to the first direction and the second direction, wherein each of the plurality of memory chips includes a respective one of a plurality of on-die termination (ODT) circuits coupled to the signal transmission line, and wherein each of the plurality of memory chips is configured to individually set a resistance value of the respective one of the plurality of ODT circuits based on respective position information of the respective memory chip relative to a surface of the PCB.

According to an aspect of the disclosure, a memory system includes: a memory controller including a central processing unit (CPU), wherein the memory controller is mounted on a printed circuit board (PCB) extending in a first direction and a second direction crossing the first direction; a first memory module including a first group of memory chips, wherein the first memory module is mounted in a first socket on the PCB, the first socket being spaced apart from the memory controller by a first distance in the first direction; and a second memory module including a second group of memory chips, wherein the second memory module is mounted in a second socket on the PCB, the second socket being spaced apart from the memory controller by a second distance in the first direction, wherein a first memory chip among the first group of memory chips and a second memory chip among the second group of memory chips communicate with the memory controller through a signal transmission line and share the signal transmission line, and each of the first memory chip and the second memory chip includes an on-die termination (ODT) circuit coupled to the signal transmission line, wherein the first memory chip is configured to set a resistance value of the ODT circuit of the first memory chip based on position information of the first memory chip associated with a distance of the first memory chip from the memory controller in the first direction, and wherein the second memory chip is configured to set a resistance value of the ODT circuit of the second memory chip based on position information of the second memory chip associated with a distance of the second memory chip from the memory controller in the first direction.

Accordingly, in one or more embodiments, the multi-chip package may include a plurality of memory chips stacked in a vertical direction from a surface of a PCB, and each of the plurality of memory chips includes a mode register and an ODT circuit. The mode register in each of the plurality of memory chips may enhance signal integrity by individually set respective resistance value of the ODT circuit based on a position of each of the plurality of memory chips in the multi-chip package.

At least some of the above and other features of the invention are set out in the claims.

### BRIEF DESCRIPTION OF DRAWINGS

The above and other aspects and features of certain embodiments of the present disclosure will be more apparent from the following description taken in conjunction with the accompanying drawings, in which:
FIG. 1 is a block diagram illustrating an example of a memory system according to one or more embodiments;
FIG. 2 is a block diagram illustrating an example of the memory controller in the storage device of FIG. 1 according to one or more embodiments;
FIG. 3 illustrates an example of a memory system of FIG. 1 according to one or more embodiments;
FIG. 4 is a block diagram illustrating an example of one of the plurality of memory chips in the multi-chip package in FIG. 3 according to one or more embodiments;
FIG. 5 illustrates an example of the first bank array in the memory chip of FIG. 4 according to one or more embodiments;
FIG. 6 illustrates an example of the data I/O buffer in the memory chip of FIG. 4 according to one or more embodiments;
FIG. 7 is a circuit diagram illustrating a transmission driver in the data I/O buffer of FIG. 6 according to one or more embodiments;
FIG. 8 is a block diagram illustrating a portion of the memory chip of FIG. 4 according to one or more embodiments;
FIG. 9 is a block diagram illustrating an example of the termination controller in the memory chip in FIG. 8 according to one or more embodiments;
FIG. 10 is a circuit diagram illustrating an example of the ODT circuit in FIG. 8 according to one or more embodiments;
FIG. 11 is a circuit diagram illustrating an example of the ODT circuit in FIG. 8 according to one or more embodiments;
FIG. 12 is a table indicating control codes that are stored in termination controllers according to one or more embodiments;
FIG. 13 is a block diagram illustrating an example of a memory chip according to one or more embodiments;
FIG. 14 is a block diagram illustrating an example of a memory chip according to one or more embodiments;
FIG. 15 illustrates an example operation of the memory system of FIG. 3 in the write mode according to one or more embodiments;
FIG. 16 illustrates an example operation of the memory system of FIG. 3 in the read mode according to one or more embodiments;
FIG. 17 is cross-sectional view of a memory package according to one or more embodiments;
FIG. 18 is a schematic illustrating a memory system according to one or more embodiments;
FIG. 19 is a block diagram illustrating a memory system of FIG. 18 according to one or more embodiments;
FIG. 20 is a block diagram illustrating a memory module that may be employed by a memory system according to one or more embodiments;
FIGS. 21 and 22 are block diagrams illustrating a memory system according to one or more embodiments;
FIG. 23 is a flow chart illustrating a method of operating a multi-chip package according to one or more embodiments; and
FIG. 24 is a block diagram illustrating a mobile system including a memory module according to one or more embodiments.

### DETAILED DESCRIPTION

One or more example embodiments will be described more fully hereinafter with reference to the accompanying drawings, in which one or more embodiments are shown.

In the following description, like reference numerals refer to like elements throughout the specification. Terms such as "unit", "module", "member", and "block" may be embodied as hardware or software. As used herein, a plurality of "units", "modules", "members", and "blocks" may be implemented as a single component, or a single "unit", "module", "member", and "block" may include a plurality of components.

It will be understood that when an element is referred to as being "connected" with or to another element, it can be directly or indirectly connected to the other element, wherein the indirect connection may include "connection via a wireless communication network".

Also, when a part "includes" or "comprises" an element, unless there is a particular description contrary thereto, the part may further include other elements, not excluding the other elements.

Throughout the description, when a member is "on" another member, this includes not only when the member is in contact with the other member, but also when there is another member between the two members.

As used herein, the expressions "at least one of a, b or c" and "at least one of a, b and c" indicate "only a," "only b," "only c," "both a and b," "both a and c," "both b and c," and "all of a, b, and c."

It will be understood that, although the terms "first", "second", "third", etc., may be used herein to describe various elements, is the disclosure should not be limited by these terms. These terms are only used to distinguish one element from another element.

As used herein, the singular forms "a," "an" and "the" are intended to include the plural forms as well, unless the context clearly indicates otherwise.

With regard to any method or process described herein, an identification code may be used for the convenience of the description but is not intended to illustrate the order of each step or operation. Each step or operation may be implemented in an order different from the illustrated order unless the context clearly indicates otherwise. One or more steps or operations may be omitted unless the context of the disclosure clearly indicates otherwise.

The various actions, acts, blocks, steps, or the like in the flow diagrams may be performed in the order presented, in a different order, or simultaneously. Further, in one or more embodiments, some of the actions, acts, blocks, steps, or the like may be omitted, added, modified, skipped, or the like without departing from the scope of the disclosure.

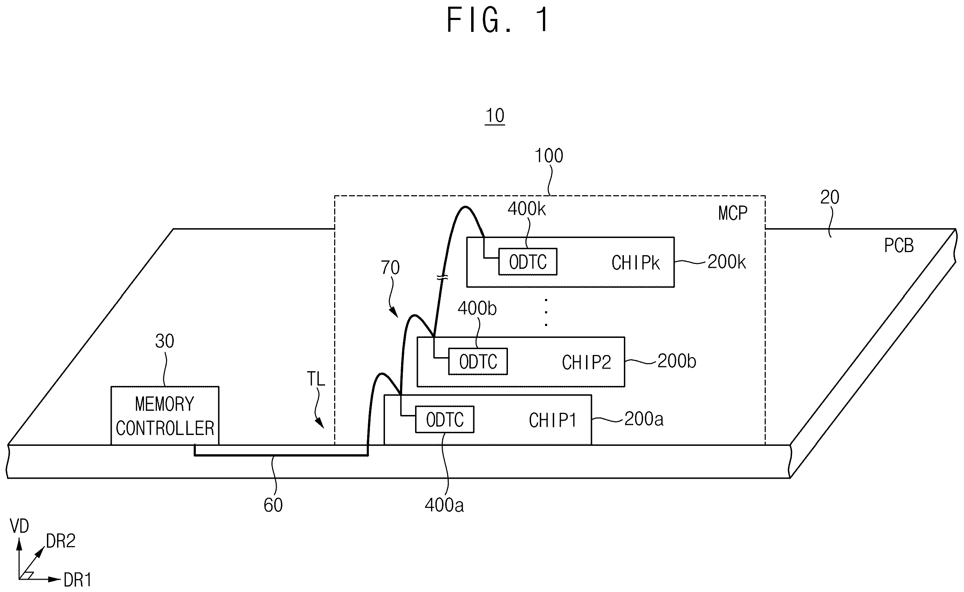

FIG. 1 is a block diagram illustrating an example of a memory system according to one or more embodiments.

Referring to FIG. 1, a memory system 10 may include a memory controller 30 and a multi-chip package 100 including a plurality of memory chips 200a, 200b, ..., 200k provided on a printed circuit board (PCB) 20. Here, k may be an integer greater than two.

The memory system 10 may be referred to as a data storage device and each of the plurality of memory chips (CHIP1, CHIP2, ..., CHIPk) 200a, 200b, ..., 200k may be a dynamic random access memory (DRAM) device. Having said this, the memory system may be any type of memory device. Each of the plurality of memory chips 200a, 200b, ..., 200k may be referred to as a memory die or a semiconductor memory device.

The memory controller 30 and the plurality of memory chips 200a, 200b, ..., 200k may be electrically coupled to each other through a signal transmission line (or data input/output (I/O) line) TL. The signal transmission line TL may include a main transmission line (or pattern) 60 and a branch transmission line (or pattern) 70. The main transmission line 60 may be electrically connected to the memory controller 30 and the branch transmission line 70 may be branched from the main transmission pattern 60 and may be connected respectively to the plurality of memory chips 200a, 200b, ..., 200k. The branch transmission line 70 may be connected to the main transmission line 60 and the plurality of memory chips 200a, 200b, ..., 200k with a daisy chain configuration. The branch transmission line 70 may include a plurality of segments, the main transmission line 60 and the memory chip 200a may be connected to each other by a first segment among the plurality of segments and the memory chip 200a and the memory chip 200b may be connected to each other by a second segment among the plurality of segments. Each segment may connect a respective adjacent pair of memory chips 200a, 200b, ..., 200k.

The PCB 20 may extend in a first direction DR1 and a second direction DR2 crossing the first direction DR1 and the plurality of memory chips 200a, 200b, ..., 200k may be stacked on the PCB 20 in a third direction VD perpendicular to the first direction DR1 and the second direction DR2. The PCB 20 may also be referred to as a board.

Each of the plurality of memory chips 200a, 200b, ..., 200k may include a respective one of a plurality of on-die termination circuits ODTC 400a, 400b, ..., 400k. The plurality of on-die termination circuits 400a, 400b, ..., 400k may be electrically connected to the signal transmission line TL. Each of the plurality of memory chips 200a, 200b, ..., 200k may individually set a resistance value of the respective one of the on-die termination circuits 400a, 400b, ..., 400k based on respective position information associated with a surface of the PCB 20. The respective position information may be determined relative to the surface of the PCB 20. The surface of the PCB 20 may be a surface upon which the plurality of memory chips 200a, 200b, ..., 200k are located. The respective position information may indicate a distance between the surface and the memory chip (e.g., in the third direction VD). For instance, the respective position information may indicate a height (e.g., a vertical position) of the memory chip within the stack of memory chips 200a, 200b, ..., 200k.

The respective position information may be associated with a length of the signal transmission line TL through which each of the plurality of memory chips 200a, 200b, ..., 200k is connected to the memory controller 30.

For example, the memory chip 200a among the plurality of memory chips 200a, 200b, ..., 200k may be connected to the memory controller 30 through the shortest portion of the signal transmission line TL and the memory chip 200k among the plurality of memory chips 200a, 200b, ..., 200k may be connected to the memory controller 30 through the longest portion of the signal transmission line TL. That is, because each of the plurality of memory chips 200a, 200b, ..., 200k may be connected to the memory controller 30 through a corresponding portion having different length, of the signal transmission line TL, the corresponding portion of the signal transmission line TL may represent different signal integrity when each of the plurality of memory chips 200a, 200b, ..., 200k transmits/receives data. When the resistance value of each of the on-die termination circuits 400a, 400b, ..., 400k is set to have same resistance value, signal integrity may be degraded based on the respective position of each of the plurality of memory chips 200a, 200b, ..., 200k in the multi-chip package 100. However, when each of the plurality of memory chips 200a, 200b, ..., 200k may individually set the resistance value of respective one of the on-die termination circuits 400a, 400b, ..., 400k, based on the respective position information associated with the surface of the PCB 20, the signal integrity may be enhanced.

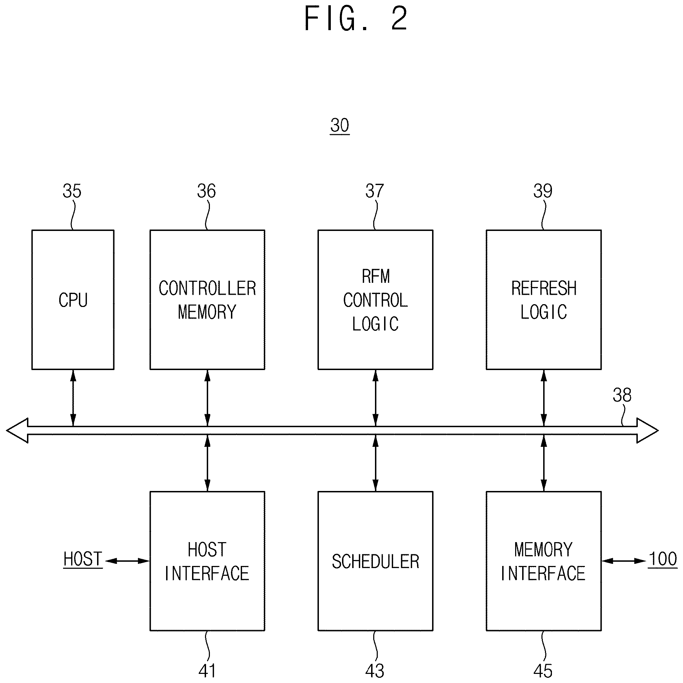

FIG. 2 is a block diagram illustrating an example of the memory controller in the storage device of FIG. 1 according to one or more embodiments.

Referring to FIG. 2, the memory controller 30 may include a central processing unit (CPU) 35, controller memory 36, a refresh management (RFM) control logic 37, a refresh logic 39, a host interface 41, a scheduler 43 and a memory interface 45 which are connected to each other through a bus 38.

The CPU 35 may control overall operation of the memory controller 30. The CPU 35 may control the RFM control logic 37, the refresh logic 39, the host interface 41, the scheduler 43 and the memory interface 45 through the bus 38.

The CPU 35 may include one or more of a central processing unit (CPU), a micro controller unit (MCU), a micro processing unit (MPU), a controller, an application processor (AP), a graphics-processing unit (GPU) or a communication processor (CP), and an advanced reduced instruction set computer (RISC) machines (ARM) processor. The CPU 35 may include one or more processors configured to work individually or collectively. Also, the memory controller 30 may be implemented as a system on chip (SoC) having a processing algorithm stored therein or large scale integration (LSI), or in the form of a field programmable gate array (FPGA). The memory controller 30 may perform various functions by executing computer executable instructions stored in memory (e.g., controller memory 36).

The refresh logic 39 may generate auto refresh commands for refreshing memory cells of a plurality of memory cell rows of each of the plurality of memory chips 200a, 200b, ..., 200k based on a refresh interval of each of the plurality of memory chips 200a, 200b, ..., 200k.

The host interface 41 may perform interfacing with a host. The memory interface 45 may perform interfacing with the multi-chip package 100.

The scheduler 43 may manage scheduling and transmission of sequences of commands generated in the memory controller 30. The scheduler 43 may transmit an auto refresh command and a refresh management command to the plurality of memory chips 200a, 200b, ..., 200k via the memory interface 45.

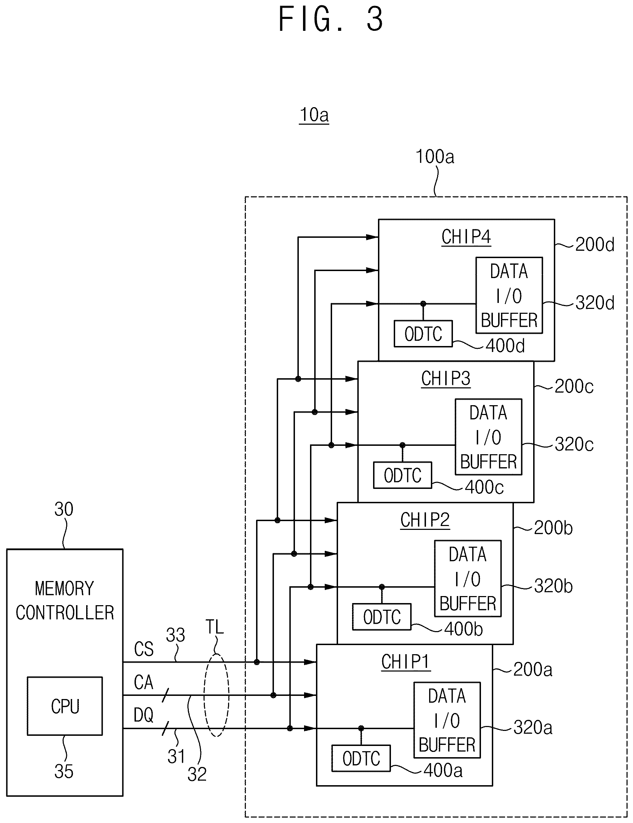

FIG. 3 illustrates an example of a memory system of FIG. 1 according to one or more embodiments.

Referring to FIG. 3, a memory system 10a may include a memory controller 30 and a multi-chip package 100a and the multi-chip package 100a may include a plurality of memory chips 200a, 200b, 200c and 200d stacked on a PCB in a third direction (VD in FIG. 1).

The memory controller 300 may include the CPU 35 and each of the plurality of memory chips 200a, 200b, 200c and 200d may include respective one of data input/output (I/O) buffers 320a, 320b, 320c and 320d and respective one of ODT circuits 400a, 400b, 400c and 400d.

The memory controller 30 may transmit a data signal DQ to the plurality of memory chips 200a, 200b, 200c and 200d through a signal line 31, may transmit a command/address (signal) CA to the plurality of memory chips 200a, 200b, 200c and 200d through a signal line 32 and may select one of the plurality of memory chips 200a, 200b, 200c and 200d by transmitting a chip selection signal CS to the plurality of memory chips 200a, 200b, 200c and 200d through a signal line 33.

The signal lines 31, 32 and 33 may correspond to the signal transmission line TL in FIG. 1. Accordingly, the signal transmission line TL may comprise a plurality of signal lines.

Each of the ODT circuits 400a, 400b, 400c and 400d may be connected between a respective one of the data I/O buffers 320a, 320b, 320c and 320d and the signal line 31 and may provide the signal line 31 with a respective resistance value, which is set individually based on respective position of each of the plurality of memory chips 200a, 200b, 200c and 200d in the multi-chip package 100a, as a termination resistance. The respective position in the multi-chip package 100a may be associated with a corresponding length of the signal transmission line TL.

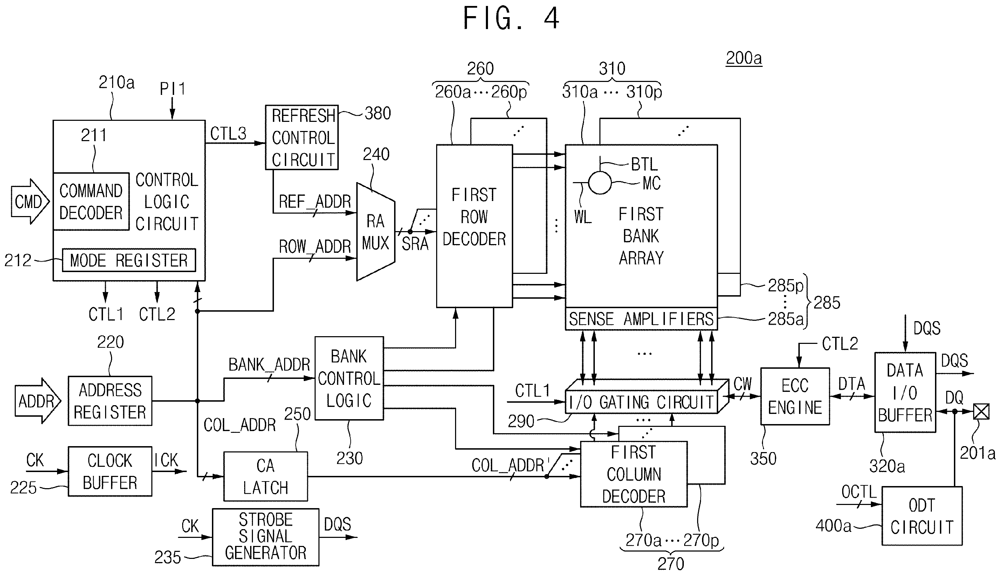

FIG. 4 is a block diagram illustrating an example of one of the plurality of memory chips in the multi-chip package in FIG. 3 according to one or more embodiments.

In FIG. 4, a configuration of the memory chip 200a is illustrated and each configuration of the memory chips 200b, 200c and 200d may be substantially the same as the configuration of the memory chip 200a.

Referring to FIG. 4, the memory chip 200a may include a memory cell array 310, a control logic circuit 210a, an address register 220, a bank control logic 230, a refresh control circuit 380, a row address multiplexer 240, a column address latch 250, a row decoder 260, a column decoder 270, a sense amplifier unit 285, an input/output (I/O) gating circuit 290, an error correction code (ECC) engine 350, a clock buffer 225, a strobe signal generator 235, the data I/O buffer 320a and the ODT circuit 400a.

The memory cell array 310 may include first through sixteenth bank arrays 310a-310p. The row decoder 260 may include first through sixteenth row decoders 260a-260p respectively coupled to the first through sixteenth bank arrays 310a-310p, the column decoder 270 may include first through sixteenth column decoders 270a-270p respectively coupled to the first through sixteenth bank arrays 310a-310p, and the sense amplifier unit 285 may include first through sixteenth sense amplifiers 285a-285p respectively coupled to the first through sixteenth bank arrays 310a-310p.

The first through sixteenth bank arrays 310a-310p, the first through sixteenth row decoders 260a-260p, the first through sixteenth column decoders 270a-270p and first through sixteenth sense amplifiers 285a-285p may form first through sixteenth banks. Each of the first through sixteenth bank arrays 310a-310p includes a plurality of memory cells MC formed at intersections of a plurality of word-lines WL and a plurality of bit-line BTL. It should be noted that the number of bank arrays, row decoders, column decoders, sense amplifiers and/or banks may be varied.

The address register 220 may receive the address ADDR including a bank address BANK_ADDR, a row address ROW_ADDR and a column address COL_ADDR from the memory controller 30 in FIG. 3. The address register 220 may provide the received bank address BANK_ADDR to the bank control logic 230, may provide the received row address ROW_ADDR to the row address multiplexer 240 and the refresh control circuit 380, and may provide the received column address COL_ADDR to the column address latch 250.

The bank control logic 230 may generate bank control signals in response to the bank address BANK_ADDR. One of the first through sixteenth row decoders 260a-260p corresponding to the bank address BANK_ADDR is activated in response to the bank control signals, and one of the first through sixteenth column decoders 270a-270p corresponding to the bank address BANK_ADDR is activated in response to the bank control signals.

The row address multiplexer 240 may receive the row address ROW_ADDR from the address register 220, and may receive a refresh row address REF_ADDR from the refresh control circuit 380. The row address multiplexer 240 may selectively output the row address ROW_ADDR or the refresh row address REF_ADDR as a row address SRA. The row address SRA that is output from the row address multiplexer 240 is applied to the first through sixteenth row decoders 260a-260p.

The refresh control circuit 380 may sequentially increase or decrease the refresh row address REF_ADDR in response to a third control signal CTL3 from the control logic circuit 210a.

The activated one of the first through sixteenth row decoders 260a-260p, by the bank control logic 230, may decode the row address SRA that is output from the row address multiplexer 240, and may activate a word-line corresponding to the row address SRA. For example, the activated bank row decoder applies a word-line driving voltage to the word-line corresponding to the row address.

The column address latch 250 may receive the column address COL_ADDR from the address register 220, and may temporarily store the received column address COL_ADDR. In one or more embodiments, in a burst mode, the column address latch 250 may generate column address COL_ADDR' that increments from the received column address COL_ADDR. The column address latch 250 may apply the temporarily stored or generated column address COL_ADDR' to the first through sixteenth column decoders 270a-270p.

The activated one of the first through sixteenth column decoders 270a-270p may activate a sense amplifier corresponding to the bank address BANK_ADDR and the column address COL_ADDR through the I/O gating circuit 290.

The I/O gating circuit 290 may include a circuitry for gating input/output data, and may further include input data mask logic, read data latches for storing data that is output from the first through sixteenth bank arrays 310a-310p, and write drivers for writing data to the first through sixteenth bank arrays 310a-310p.

A codeword CW read from a selected one bank array of the first through sixteenth bank arrays 310a-310p may be sensed by a sense amplifier coupled to the selected one bank array from which the data is to be read, and may be stored in the read data latches. The codeword CW stored in the read data latches may be provided to the data I/O buffer 320a as data DTA after ECC decoding is performed on the codeword CW by the ECC engine 350. The data I/O buffer 320a may convert the data DTA into the data signal DQ and may transmit the data signal DQ along with the data strobe signal DQS to the external memory controller.

The data signal DQ to be written in a selected one bank array of the first through sixteenth bank arrays 310a-310p may be provided to the data I/O buffer 320a from the memory controller 30. The data I/O buffer 320 may convert the data signal DQ to the data DTA and may provide the data DTA to the ECC engine 350. The ECC engine 350 may perform an ECC encoding on the data DTA to generate parity bits, and the ECC engine 350 may provide the codeword CW including data DTA and the parity bits to the I/O gating circuit 290. The I/O gating circuit 290 may write the codeword CW in a sub-page in the selected one bank array through the write drivers.

The data I/O buffer 320a may provide the data signal DQ from the memory controller 30 to the ECC engine 350 by converting the data signal DQ to the data DTA in a write operation of the memory chip 200a and may convert the data DTA to the data signal DQ from the ECC engine 350 and may transmit the data signal DQ and the data strobe signal DQS to the memory controller 30 in a read operation of the memory chip 200a.

The ECC engine 350 may perform an ECC encoding on the data DTA and may perform an ECC decoding on the codeword CW based on a second control signal CTL2 from the control logic circuit 210a.

The clock buffer 225 may receive the clock signal CK, may generate an internal clock signal ICK by buffering the clock signal CK, and may provide the internal clock signal ICK to circuit components processing the command CMD and the address ADDR.

The strobe signal generator 235 may receive the clock signal CK, may generate the data strobe signal DQS based on the clock signal CK and may provide the data strobe signal DQS to the data I/O buffer 320a.

The ODT circuit 400a may be connected between a data I/O pin (e.g., pad) 201a and the data I/O buffer 320a and may provide a termination resistance to a signal line connected between the data I/O pin 201a and the data I/O buffer 320a based on an ODT control signal OCTL.

The control logic circuit 210a may control operations of the memory chip 200a. For example, the control logic circuit 210a may generate control signals for the memory chip 200a in order to perform a write operation, a read operation and a refresh operation. The control logic circuit 210a includes a command decoder 211 that decodes the command CMD received from the memory controller 30 and a mode register 212 that sets an operation mode of the memory chip 200a.

For example, the command decoder 211 may generate the control signals corresponding to the command CMD by decoding a write enable signal, a row address strobe signal, a column address strobe signal, a chip select signal, etc. The control logic circuit 210a may generate a first control signal CTL1 to control the I/O gating circuit 290, a second control signal CTL2 to control the ECC engine 350 and the third control signal CTL3 to control the refresh control circuit 380. In addition, the control logic circuit 210a may generate the ODT control signal OCTL to control the ODT circuit 400a based on position information PI1 indicating a position of the memory chip 200a in the multi-chip package 100a and may provide the ODT control signal OCTL to the ODT circuit 400a.

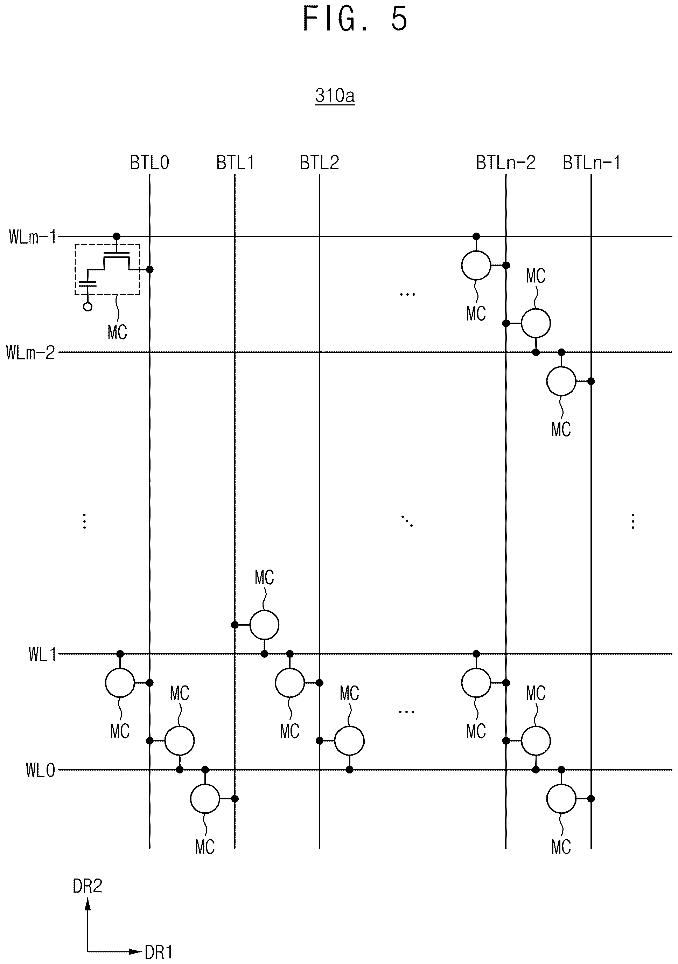

FIG. 5 illustrates an example of the first bank array in the memory chip of FIG. 4 according to one or more embodiments.

Referring to FIG. 5, the first bank array 310a may include a plurality of word-lines WL0-WLm-1 (m is a natural number greater than two), a plurality of bit-lines BTL0-BTLn-1 (n is a natural number greater than two), and a plurality of memory cells MCs disposed at intersections between the word-lines WL0-WLm-1 and the bit-lines BTL0-BTLn-1. Each of the memory cells MCs includes a cell transistor coupled to each of the word-lines WL0-WLm-1 and each of the bit-lines BTL0-BTLn-1 and a cell capacitor coupled to the cell transistor. For instance, each of the memory cells MCs may have a DRAM cell structure; however, the disclosure is not limited thereto. For instance, other forms of memory cells may be utilized, such as NAND memory cells, resistive random access memory (ReRAM) cells, phase change RAM (PRAM) cells, and/or magnetic RAM (MRAM) cells.

Each of the word-lines WL0-WLm-1 extends in the first direction DR1 and each of the bit-lines BTL0-BTLn-1 extends in the second direction DR2 crossing the first direction DR1.

The word-lines WL0-WLm-1 coupled to the plurality of memory cells MCs may be referred to as rows of the first bank array 310a and the bit-lines BTL0-BTLn-1 coupled to the plurality of memory cells MCs may be referred to as columns of the first bank array 310a.

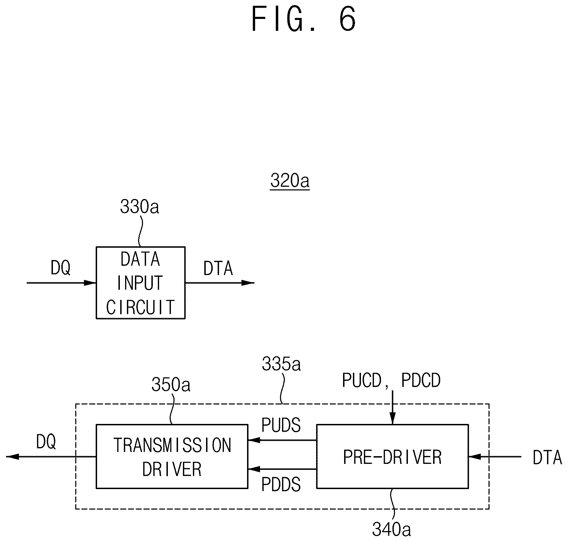

FIG. 6 illustrates an example of the data I/O buffer in the memory chip of FIG. 4 according to one or more embodiments.

Referring to FIG. 6, the data I/O buffer 320a may include a data input circuit 330a and a data output circuit 335a. The data output circuit 335a may include a pre-driver 340a and a transmission driver 350a.

The data input circuit 330a may receive the data signal DQ from the memory controller 30, may convert the data signal DQ into the data DTA, and may provide the data DTA to the ECC engine 350. The data output circuit 335a may convert the data DTA from the ECC engine 350 to the data signal DQ and may provide the data signal DQ to the memory controller 30.

The pre-driver 340a may receive the data DTA, may generate a pull-up driving signal PUDS and a pull-down driving signal PDDS based on a pull-up control code PUCD and a pull-down control code PDCD, and may provide the pull-up driving signal PUDS and the pull-down driving signal PDDS to the transmission driver 350a. The pull-up control code PUCD and the pull-down control code PDCD may be provided from an impedance calibration circuit that may be included in the memory chip 200a of FIG. 4.

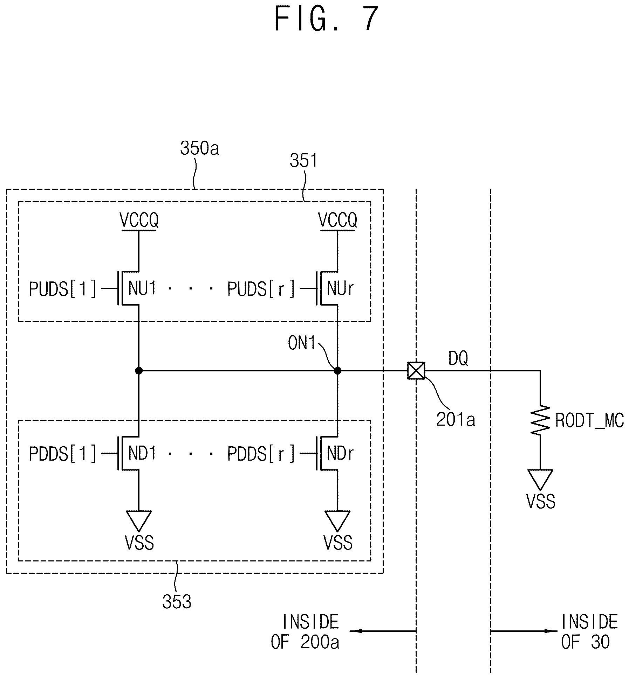

For example, when the data DTA is at a high level, the pre-driver 340a may buffer the pull-up control code PUCD and generate the pull-up driving signal PUDS to be substantially the same as the pull-up control code PUCD, and may generate the pull-down driving signal PDDS for turning off all transistors included in a pull-down driver (such as a pull-down driver 353 shown in FIG. 7) of the transmission driver 350a. Contrarily, when the data DTA is at a low level, the pre-driver 340a may buffer the pull-down control code PDCD and generate the pull-down driving signal PDDS to be substantially the same as the pull-down control code PDCD, and generate the pull-up driving signal PUDS for turning off all transistors included in a pull-up driver (such as a pull-up driver 351 shown in FIG. 7) of the transmission driver 350a. The pre-driver 340a may determine a current generated by the pull-up driver 351 and a resistance of the pull-down driver 353 (shown in FIG.7) when the transmission driver 350a outputs the data signal DQ.

FIG. 7 is a circuit diagram illustrating a transmission driver in the data I/O buffer of FIG. 6 according to one or more embodiments.

Referring to FIG. 7, the transmission driver 350a may include a pull-up driver 351 and a pull-down driver 353.

The pull-up driver 351 may include first through r-th (where r is a natural number greater than one) pull-up transistors NU1 through NUr connected between a power supply voltage VCCQ and an output node ON1. Each of the first through r-th pull-up transistors NU1 through NUr may be an n-type metal oxide semiconductor (NMOS) transistor.

The pull-down driver 353 may include first through r-th pull-down transistors ND1 through NDr connected between the output node ON1 and a ground voltage VSS. Each of the first through r-th pull-down transistors ND1 through NDr may be an NMOS transistor.

When the data DTA is at the high level, the pull-up driver 351 may receive the pull-up driving signal PUDS (e.g., PUDS[1] through PUDS[r]) corresponding to the pull-up control code PUCD from the pre-driver 340a and generate the current determined by the pull-up control code PUCD. The pull-down transistors ND1 through NDr included in the pull-down driver 353 may all be turned off according to the pull-down driving signal PDDS (e.g., PDDS[1] through PDDS[r]).

The current generated by the pull-up driver 351 may be transmitted to an on-die termination (ODT) resistor RODT_MC in the memory controller 30 via the data I/O pin 201a. The data signal DQ that the ODT resistor RODT_MC receives is determined by the current generated by the pull-up driver 351 and the ODT resistor RODT_MC.

When the data DTA is at the low level, the pull-up transistors NU1 through NUr included in the pull-up driver 351 may all be turned off according to the pull-up driving signal PUDS. The pull-down driver 353 may receive the pull-down driving signal PDDS corresponding to the pull-down control code PDCD from the pre-driver 340a and may have a resistance determined by the pull-down control code PDCD.

At this time, no current is generated by the pull-up driver 351, and therefore, the data signal DQ that the ODT resistor RODT_MC receives has an output low level voltage which is substantially the same as the ground voltage VSS.

According to one or more embodiments, the total resistance, e.g., a termination resistance (RTT), of the pull-up driver 351 or the pull-down driver 353 may be changed in response to a particular pull-up or pull-down driving signal PUDS or PDDS.

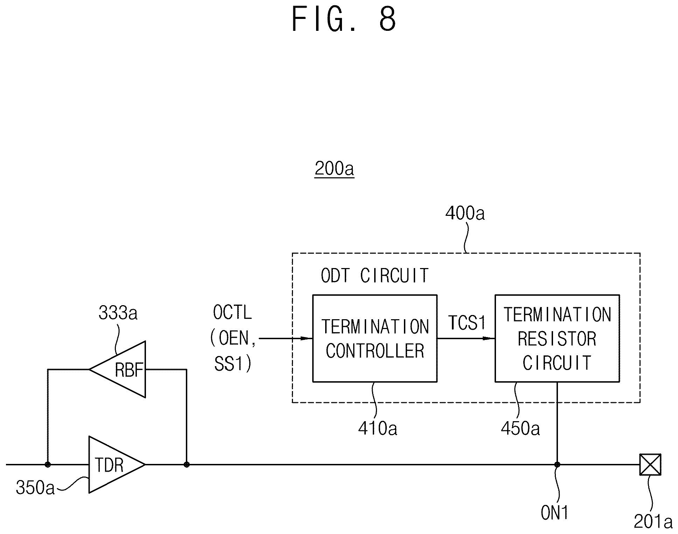

FIG. 8 is a block diagram illustrating a portion of the memory chip of FIG. 4 according to one or more embodiments.

In FIG. 8, a reception buffer RBF 333a, the transmission driver 350a and the ODT circuit 400a in the memory chip 200a are illustrated.

Referring to FIG. 8, the reception buffer 333a, the transmission driver 350a and the ODT circuit 400a may be coupled to the data I/O pin 201a at an output node ON1. The transmission driver 350a may drive the data I/O pin 201a based on read data and the reception buffer 333a may receive write data provided through the data I/O pin 201a.

The ODT circuit 400a may include a termination controller 410a and a termination resistor circuit 450a.

The termination resistor circuit 450a may be coupled to the data I/O pin 201a and may provide termination impedance (resistance) to a signal transmission line coupled to the data I/O pin 201a.

The method of controlling ODT according to one or more embodiments may be applied to control terminations of data I/O pins for bidirectional communication between the memory controller 30 and the memory chip. Thus, the method according to one or more embodiments may be applied to a data strobe pin, a data mask pin, or a termination data strobe pin in addition to the data I/O pin 201a. The term "pin" broadly refers to an electrical interconnection for an integrated circuit, e.g., a pad or other electrical contact on the integrated circuit.

In one or more embodiments, the termination resistor circuit 450a may perform a pull-up termination operation to provide termination resistance between a power supply voltage node and the data I/O pin 201a and/or a pull-down termination operation to provide termination resistance between a ground node and the data I/O pin 201a.

Even though FIG. 8 illustrates an embodiment where a distinct termination resistor circuit 450a is equipped, a signal driver itself in the transmission driver 350a may function as termination resistors. For example, in the write operation, the transmission driver 350a does not transmit read data and so the transmission driver 350a may function as the termination resistor circuit 450a while the reception buffer 333a is enabled to receive write data.

When the termination resistor circuit 450a performs the pull-up termination operation, a voltage of the signal transmission line connected to the data I/O pin 201a may be maintained substantially at a level of the power supply voltage. As a result, a current flows through the termination resistor circuit 450a and the signal transmission line only when data of a logic low level are transferred.

The termination controller 410a may receive the ODT control signal OCTL and may generate a termination control signal TCS1 for controlling the termination resistor circuit 450a. The ODT control signal OCTL may include a selection signal SS1 and an output enable signal OEN.

In one or more embodiments, the output enable signal OEN is activated during a read operation. While the output enable signal OEN is active, the termination controller 410a may provide the termination control signal TCS1 at a predetermined logic level to control the termination resistor circuit 450a not to provide the termination impedance. In that case, the termination resistor circuit 450a may be electrically decoupled from the data I/O pin 201a in response to the termination control signal TCS1 having the predetermined logic level. When the termination resistor circuit 450a is electrically decoupled from the data I/O pin 201a, the ODT circuit 400a or the termination resistor circuit 450a may be referred to as "being disabled".

While the output enable signal OEN is deactivated during a write operation, the termination controller 410a may generate the termination control signal TCS1 to control the termination resistor circuit 450a to provide the termination impedance.

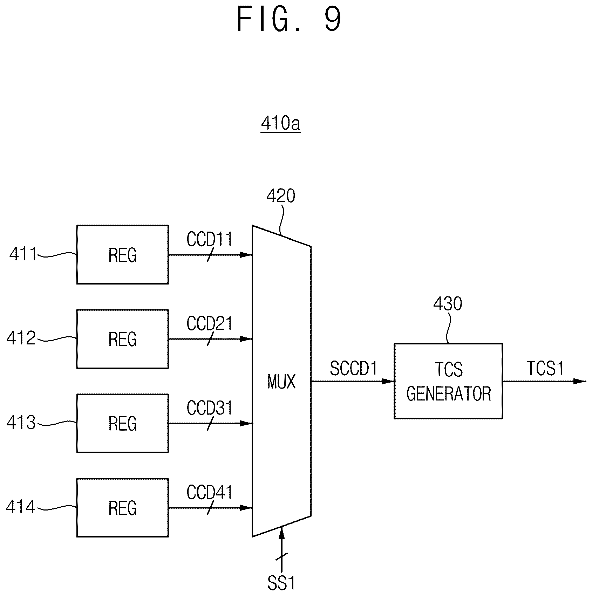

FIG. 9 is a block diagram illustrating an example of the termination controller in the memory chip in FIG. 8 according to one or more embodiments.

Referring to FIG. 9, the termination controller 410a may include a plurality of registers REGs 411, 412, 413 and 414, a multiplexer MUX 420, and a termination control signal (TCS) generator 430.

Each of the plurality of registers REGs 411, 412, 413 and 414 may store a respective one of a plurality of control codes CCD11, CCD21, CCD31 and CCD41 which are determined based on (or, associated with) a position information of the memory chip 200a, whether the memory chip 200a is selected and whether the ODT circuit 400a is enabled. For example, the plurality of control codes CCD11, CCD21, CCD31 and CCD41 may be associated with potential resistance values of the memory chip 200a.

The multiplexer 420, based on the selection signal SS1, may output one of the plurality of control codes CCD11, CCD21, CCD31 and CCD41 as a selected control code SCCD1 and may provide the selected control code SCCD1 to the TCS generator 430. The TCS generator 430 may generate the termination control signal TCS1 based on the selected control code SCCD1 and may provide the termination control signal TCS1 to the termination resistor circuit 450a.

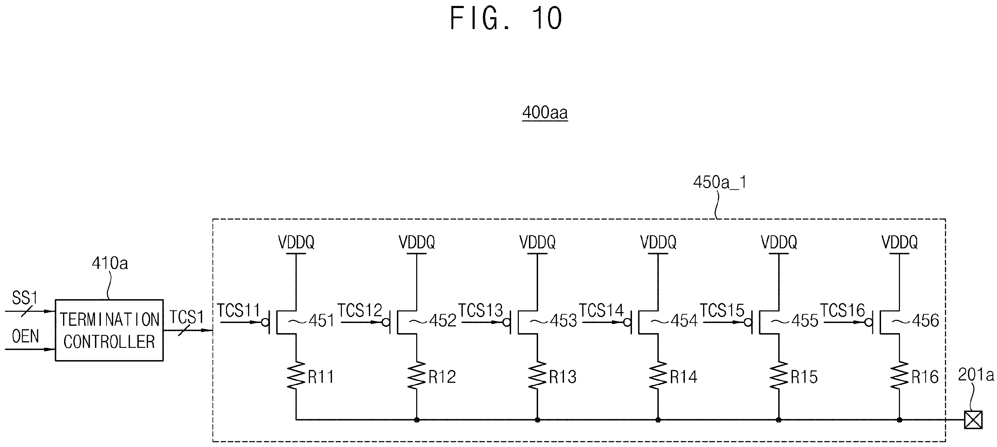

FIG. 10 is a circuit diagram illustrating an example of the ODT circuit in FIG. 8 according to one or more embodiments.

Referring to FIG. 10, an ODT circuit 400aa may include the termination controller 410a and a termination resistor circuit 450a_1.

The termination resistor circuit 450a_1 may include first through sixth p-channel metal-oxide semiconductor (PMOS) transistors 451, 452, 453, 454, 455 and 456 and first through sixth resistors R11, R12, R13, R14, R15 and R16. Each of the first through sixth PMOS transistors 451, 452, 453, 454, 455 and 456 is connected to respective one of the first through sixth resistors R11, R12, R13, R14, R15 and R16 in series between a power supply voltage VDDQ and the data I/O pin 201a.

The termination controller 410a may generate the termination control signal TCS1 based on the selection signal SS1 and the output enable signal OEN and may provide the termination control signal TCS1 to the first through sixth PMOS transistors 451, 452, 453, 454, 455 and 456. The termination controller 410a may apply each of bits TCS11, TCS12, TCS13, TCS14, TCS15 and TCS16 of the termination control signal TCS1 to a respective gate of the first through sixth PMOS transistors 451, 452, 453, 454, 455 and 456 and the termination resistance of the termination resistor circuit 450a may be adjusted based on logic levels of the bits TCS11, TCS12, TCS13, TCS14, TCS15 and TCS16 of the termination control signal TCS1.

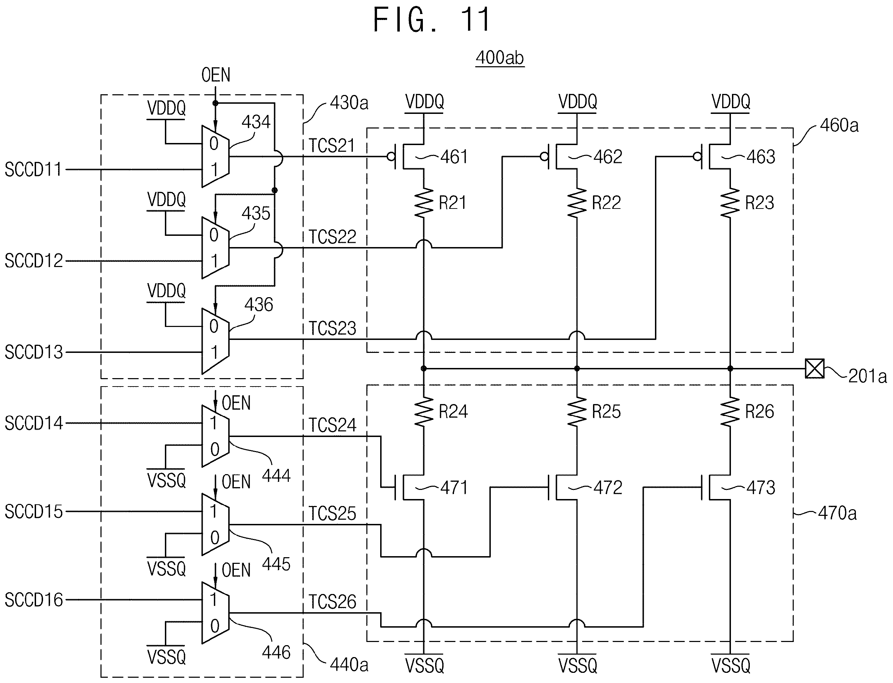

FIG. 11 is a circuit diagram illustrating an example of the ODT circuit in FIG. 8 according to one or more embodiments.

Referring to FIG. 11, an ODT circuit 400ab includes a pull-up termination control unit 430a, a pull-down termination control unit 440a, a pull-up termination unit (or a pull-up driver) 460a and a pull-down termination unit (or a pull-down driver) 470a.

The pull-up termination control unit 430a may include first to third selectors 434, 435 and 436 (e.g., multiplexers), and the pull-down termination control unit 440a may include fourth to sixth selectors 444, 445 and 446 (e.g., multiplexers). The pull-up driver 460a may include first through third PMOS transistors 461, 462 and 463 and first through third resistors R21, R22 and R23. The first through third PMOS transistors 461, 462 and 463 are connected to a power supply voltage VDDQ, and each of the first through third resistors R21, R22 and R23 is connected between a respective one of the first through third PMOS transistors 461, 462 and 463 and the data I/O pin 201a. The pull-down driver 470a may include first to third NMOS transistors 471, 472 and 473 and fourth to sixth resistors R24, R25 and R26. The first through third NMOS transistors 471, 472 and 473 are connected to a ground voltage VSSQ, and each of the fourth through sixth resistors R24, R25 and R26 is connected between a respective one of the first through third NMOS transistors 471, 472 and 473 and the data I/O pin 201a.

Each of the first through third selectors 434, 435 and 436 may receive the power supply voltage VDDQ as each of first inputs, first through third selected control code bits SCCD11, SCCD12, and SCCD13 as each of second inputs and the output enable signal OEN as each of control signals. Each of the fourth through sixth selectors 444, 445 and 446 may receive the ground voltage VDDQ as each of first inputs, fourth through sixth selected control code bits SCCD14, SCCD15, and SCCD16 as each of second inputs and the output enable signal OEN as each of control signals.

While the output enable signal OEN is activated at a logic high level during a read operation (e.g., a read mode), the first through third selectors 434, 435 and 436 may output first to third termination control signals TCS21, TCS22 and TCS23 of logic high level and the fourth through sixth selectors 444, 445 and 446 may output fourth to sixth termination control signals TCS24, TCS25 and TCS26 of logic low level.

While the output enable signal OEN is deactivated at logic low level during a write operation (e.g., a write mode), first through third selectors 434, 435 and 436 may output the first through third selected control code bits SCCD11, SCCD12 and SCCD13 to the pull-up termination unit 460a as the first through third termination control signals TCS21, TCS22 and TCS23 and the fourth through sixth selectors 444, 445 and 446 may output the fourth to sixth selected control code bits SCCD14, SCCD15 and SCCD16 to the pull-down termination unit 470a as the fourth through sixth termination control signals TCS24, TCS25 and TCS26.

Although each of the first through sixth resistors R21, R22, R23, R24, R25 and R26 is illustrated in FIG. 11 as a single resistor, in one or more embodiments each of the first through sixth resistors R21, R22, R23, R24, R25 and R26 may be implemented with a plurality of resistors that are connected in parallel and/or in series and a plurality of transistors for controlling connections of the plurality of resistors.

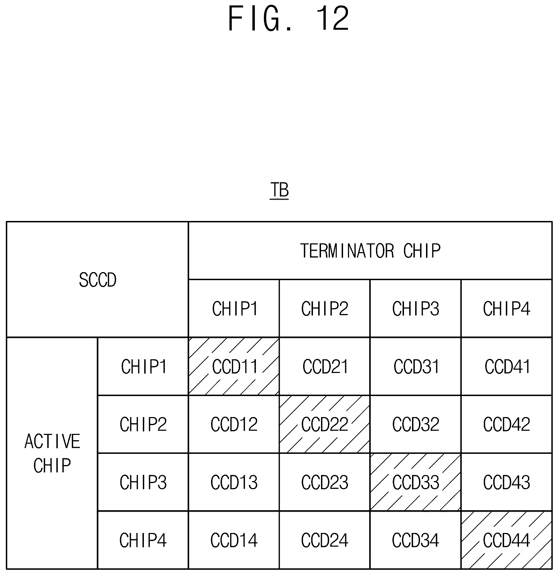

FIG. 12 is a table indicating control codes that are stored in termination controllers according to one or more embodiments.

Referring to FIG. 12, a table TB indicates that a plurality of control codes CCD11, CCD21, CCD31, CCD41, CCD12, CCD22, CCD32, CCD42, CCD13, CCD23, CCD33, CCD43, CCD14, CCD24, CCD34 and CCD44. The plurality of control codes CCD11, CCD21, CCD31, CCD41, CCD12, CCD22, CCD32, CCD42, CCD13, CCD23, CCD33, CCD43, CCD14, CCD24, CCD34 and CCD44 may be determined based on (or, may be associated with) position information of each of the plurality of memory chips 200a, 200b, 200c and 200d, whether each of the plurality of memory chips 200a, 200b, 200c and 200d are selected, and whether each of the ODT circuits 400a, 400b, 400c and 400d are enabled. That is, the plurality of control codes CCD11, CCD21, CCD31, CCD41, CCD12, CCD22, CCD32, CCD42, CCD13, CCD23, CCD33, CCD43, CCD14, CCD24, CCD34 and CCD44 may correspond to a selection state of each of the plurality of memory chips 200a, 200b, 200c and 200d and a state of enablement of each of the ODT circuits 400a, 400b, 400c and 400d.

In the table TB, "active chip" denotes a selected (enabled) memory chip among the plurality of memory chips 200a, 200b, 200c and 200d, "terminator chip" denotes a memory chip including an enabled ODT circuit among the plurality of ODT circuits 400a, 400b, 400c and 400d, and "SCCD" denotes a selected control code among the plurality of control codes CCD11, CCD21, CCD31, CCD41, CCD12, CCD22, CCD32, CCD42, CCD13, CCD23, CCD33, CCD43, CCD14, CCD24, CCD34 and CCD44. In addition, in the table TB, hatched portions denote control codes CCD11, CCD22, CCD33 and CCD44 when a selected memory chip among the plurality of memory chips 200a, 200b, 200c and 200d and an ODT circuit included in the selected memory chip is enabled.

The control code CCD11 may be associated with a case where the memory chip 200a among the plurality of memory chips 200a, 200b, 200c and 200d is selected and the ODT circuit 400a included in the memory chip 200a is enabled.

The control code CCD12 may be associated with a case where the memory chip 200b among the plurality of memory chips 200a, 200b, 200c and 200d is selected and the ODT circuit 400a included in the memory chip 200a is enabled. The control code CCD22 may be associated with a case where the memory chip 200b among the plurality of memory chips 200a, 200b, 200c and 200d is selected and the ODT circuit 400b included in the memory chip 200b is enabled.

The control code CCD32 may be associated with a case where the memory chip 200b among the plurality of memory chips 200a, 200b, 200c and 200d is selected and the ODT circuit 400c included in the memory chip 200c is enabled. The control code CCD42 may be associated with a case where the memory chip 200b among the plurality of memory chips 200a, 200b, 200c and 200d is selected and the ODT circuit 400d included in the memory chip 200d is enabled.

The control code CCD13 may be associated with a case where the memory chip 200c among the plurality of memory chips 200a, 200b, 200c and 200d is selected and the ODT circuit 400a included in the memory chip 200a is enabled. The control code CCD23 may be associated with a case where the memory chip 200c among the plurality of memory chips 200a, 200b, 200c and 200d is selected and the ODT circuit 400b included in the memory chip 200b is enabled.

The control code CCD33 may be associated with a case where the memory chip 200c among the plurality of memory chips 200a, 200b, 200c and 200d is selected and the ODT circuit 400c included in the memory chip 200c is enabled. The control code CCD43 may be associated with a case where the memory chip 200c among the plurality of memory chips 200a, 200b, 200c and 200d is selected and the ODT circuit 400d included in the memory chip 200d is enabled.

The control code CCD14 may be associated with a case where the memory chip 200d among the plurality of memory chips 200a, 200b, 200c and 200d is selected and the ODT circuit 400a included in the memory chip 200a is enabled. The control code CCD24 may be associated with a case where the memory chip 200d among the plurality of memory chips 200a, 200b, 200c and 200d is selected and the ODT circuit 400b included in the memory chip 200b is enabled.

The control code CCD34 may be associated with a case where the memory chip 200d among the plurality of memory chips 200a, 200b, 200c and 200d is selected and the ODT circuit 400c included in the memory chip 200c is enabled. The control code CCD44 may be associated with a case where the memory chip 200d among the plurality of memory chips 200a, 200b, 200c and 200d is selected and the ODT circuit 400d included in the memory chip 200d is enabled.

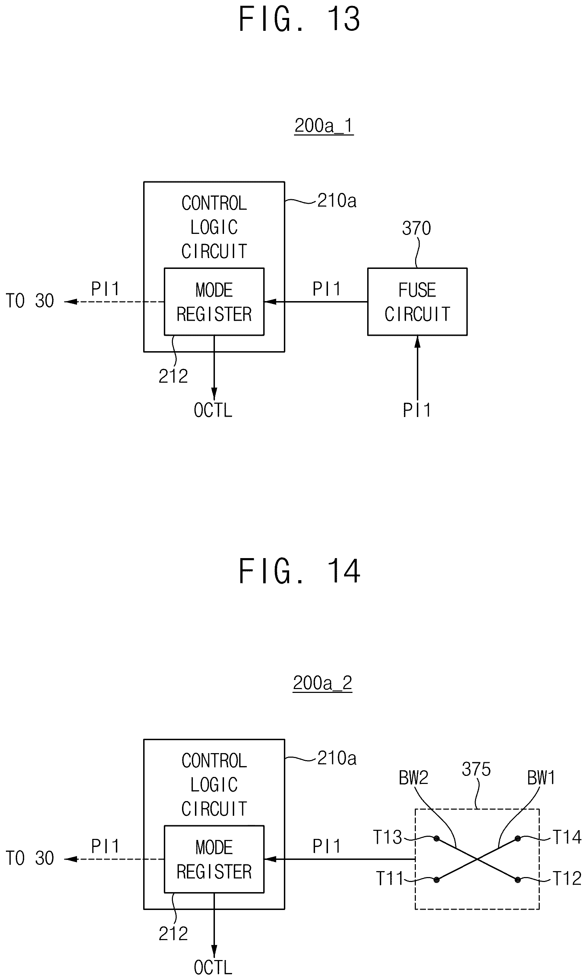

FIG. 13 is a block diagram illustrating an example of a memory chip according to one or more embodiments.

Referring to FIG. 13, a memory chip 200a_1 may include a control logic circuit 210a and a fuse circuit 370.

A position information PI1 of the memory chip 200a_1 may be programmed (e.g., stored) in the fuse circuit 370 during the fabrication process of a multi-chip package including the memory chip 200a_1, the position information PI1 is provided to a mode register 212 in the control logic circuit 210a after the memory chip 200a_1 (or, the multi-chip package including the memory chip 200a_1) is powered-on and the mode register 212 may generate an ODT control signal OCTL based on the position information PI1. For example, the mode register 212 may change the resistance value of the ODT circuit 400a based on the position information PI1 and based on whether the memory chip 200a_1 is selected by a respective chip selection signal among a plurality of chip selection signals.

In one or more embodiments, the position information PI1 programmed in the mode register 212 may be transmitted to the memory controller 30 during a power-up sequence of the multi-chip package 100a and the memory controller 30 may control the memory chip 200a_1 such that the memory chip 200a_1 sets a corresponding resistance value of the ODT circuit 400a based on the position information PI1.

The control logic circuit 210a may be referred to as a first control logic circuit, the fuse circuit 370 may be referred to as a first fuse circuit, the mode register 212 may be referred to as a first mode register, the position information PI1 may be referred to as a first position information, and the ODT circuit 400a may be referred to as a first ODT circuit.

The first control logic circuit, the first fuse circuit and the first mode register may be included in each of the memory chips 200a, 200b, 200c and 200d.

FIG. 14 is a block diagram illustrating an example of a memory chip according to one or more embodiments.

Referring to FIG. 14, a memory chip 200a_2 may include a control logic circuit 210a and a connection circuit 375.

The connection circuit 375 may include terminals T11, T12, T13 and T14. The terminals T11 and T14 may be connected to each other by a bonding wire BW1 and the terminals T12 and T13 may be connected to each other by a bonding wire BW2. The connection of the terminals T11 and T14 and the connection of the T12 and T13 (also referred to as the internal bonding configuration of the connection circuit) may indicate a position information PI1 of the memory chip 200a_2, and the mode register 212 may identity the position information PI1 of the memory chip 200a_2 based on a connection relationship of the terminals T11, T12, T13 and T14. The mode register 212 may generate an ODT control signal OCTL based on the position information PI1.

A position information PI1 of the memory chip 200a_1 may be programmed in the fuse circuit 370 during a fabricating process of a multi-chip package including the memory chip 200a_1. Alternatively, the position information PI1 of the memory chip 200a_1 may be set based on a connection relationship of the terminals T11, T12, T13 and T14 which is set during a fabricating process of a multi-chip package including the memory chip 200a_1. The position information PI1 may be provided to (or determined by) a mode register 212 in the control logic circuit 210a after the memory chip 200a_1 (or, the multi-chip package including the memory chip 200a_1) is powered-on and the mode register 212 may generate an ODT control signal OCTL based on the position information PI1.

In one or more embodiments, the position information PI1 set by the mode register 212 may be transmitted to the memory controller 30 during a power-up sequence of the multi-chip package 100a and the memory controller 30 may control the memory chip 200a_2 such that the memory chip 200a_2 sets a corresponding resistance value of the ODT circuit 400a based on the position information PI1.

In one or more embodiments, the connection circuit 375 may referred to as a first connection circuit and the first connection circuit may be included in each of the memory chips 200a, 200b, 200c and 200d.

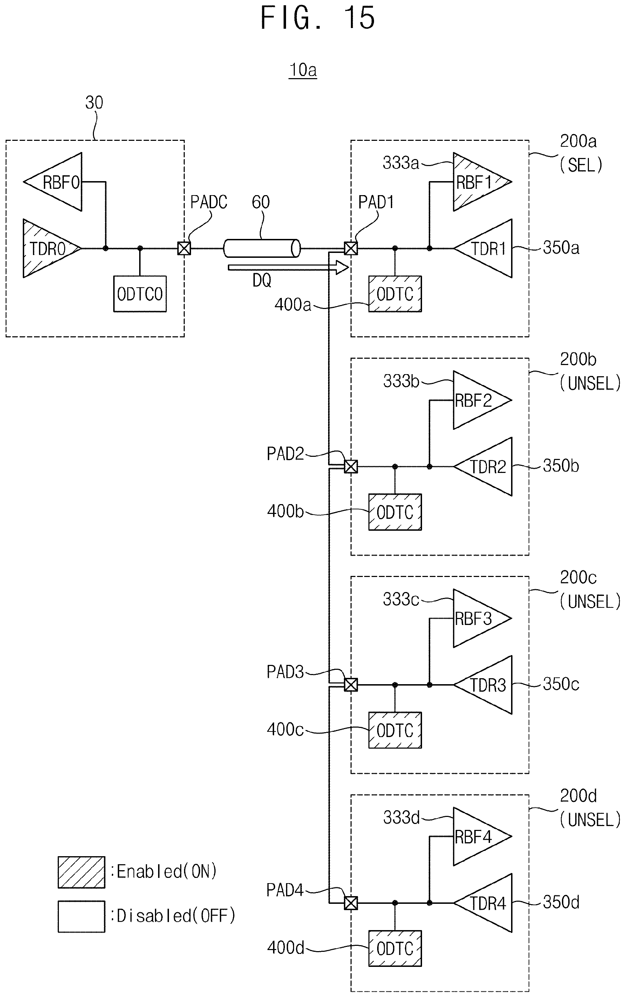

FIG. 15 illustrates an example operation of the memory system of FIG. 3 in the write mode according to one or more embodiments.

In FIG. 15, it is assumed that among the plurality of memory chips 200a, 200b, 200c and 200d, the memory chip 200a is selected as the target memory chip by the memory controller 30, and the memory chips 200b, 200c and 200d are unselected. In addition, it is assumed that the ODT circuits 400b, 400c and 400d in the memory chips 200b, 200c and 200d are enabled. In FIG. 15, the enabled elements are hatched.

Referring to FIG. 15, the memory controller 30 may be connected to the memory chips 200a, 200b, 200c and 200d through data I/O pins PADC, PAD1, PAD2, PAD3 and PAD4, the main transmission line 60 and the branch transmission line 70 in FIG. 1. The main transmission line 60 may be connected to the data I/O pin PAD1 of the memory chip 200a through a first segment of the branch transmission line 70, the data I/O pin PAD2 of the memory chip 200b may be connected to the data I/O pin PAD1 of the memory chip 200a through a second segment of the branch transmission line 70, the data I/O pin PAD3 of the memory chip 200c may be connected to the data I/O pin PAD2 of the memory chip 200b through a third segment of the branch transmission line 70 and the data I/O pin PAD4 of the memory chip 200d may be connected to the data I/O pin PAD3 of the memory chip 200c through a fourth segment of the branch transmission line 70. That is, the branch transmission line 70 in FIG. 1 may connect the main transmission line 60 and the memory chips 200a, 200b, 200c and 200d with a daisy chain configuration.

During the write mode (write operation) in which the data signal DQ is transmitted to the selected memory chip 200a from the memory controller 30, a transmission driver TDR0 is enabled and a reception buffer RBF0 and an ODT circuit ODTC0 are disabled in the memory controller 30. The reception buffer 333a and the ODT circuit 400a are enabled and the transmission driver 350a is disabled in the selected memory chip 200a. In addition, reception buffers 333b, 333c and 333d and the transmission drivers 350b, 350c and 350d are disabled in the memory chips 200b, 200c and 200d corresponding to unselected memory chips. In addition, the ODT circuits 400b, 400c and 400d in the memory chips 200b, 200c and 200d are enabled. A respective resistance value of each of the ODT circuits 400a, 400b, 400c and 400d may be individually set based on the respective position of each of the memory chips 200a, 200b, 200c and 200d in the multi-chip package 100a.

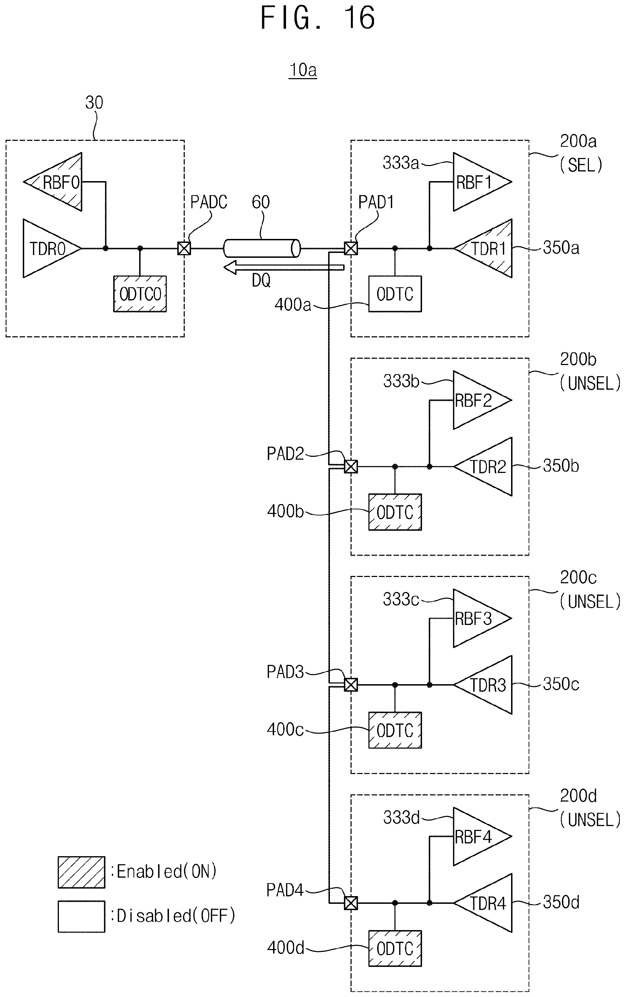

FIG. 16 illustrates an example operation of the memory system of FIG. 3 in the read mode according to one or more embodiments.

In FIG. 16, it is assumed that among the plurality of memory chips 200a, 200b, 200c and 200d, the memory chip 200a is selected as the target memory chip by the memory controller 30, and the memory chips 200b, 200c and 200d are unselected. In addition, it is assumed that the ODT circuits 400b, 400c and 400d in the memory chips 200b, 200c and 200d are enabled. In FIG. 16, the enabled elements are hatched.

Referring to FIG. 16, the memory controller 30 may be connected to the memory chips 200a, 200b, 200c and 200d through data I/O pins PADC, PAD1, PAD2, PAD3 and PAD4, the main transmission line 60 and the branch transmission line 70 in FIG. 1. The main transmission line 60 may be connected to the data I/O pin PAD1 of the memory chip 200a through a first segment of the branch transmission line 70, the data I/O pin PAD2 of the memory chip 200b may be connected to the data I/O pin PAD1 of the memory chip 200a through a second segment of the branch transmission line 70, the data I/O pin PAD3 of the memory chip 200c may be connected to the data I/O pin PAD2 of the memory chip 200b through a third segment of the branch transmission line 70 and the data I/O pin PAD4 of the memory chip 200d may be connected to the data I/O pin PAD3 of the memory chip 200c through a fourth segment of the branch transmission line 70. That is, the branch transmission line 70 in FIG. 1 may connect the main transmission line 60 and the memory chips 200a, 200b, 200c and 200d with a daisy chain configuration.

During the read mode (read operation) in which the data signal DQ is transmitted to the memory controller 30 from the memory chip 200a, a transmission driver TDR0 is disabled and the reception buffer RBF0 and the ODT circuit ODTC0 are enabled in the memory controller 30. The transmission driver 350a is enabled and the ODT circuit 400a and the reception buffer 333a are disabled in the memory chip 200a corresponding to a selected memory chip. In addition, reception buffers 333b, 333c and 333d and the transmission drivers 350b, 350c and 350d are disabled in the memory chips 200b, 200c and 200d corresponding to unselected memory chips. In addition, the ODT circuits 400b, 400c and 400d in the memory chips 200b, 200c and 200d are enabled. Respective resistance values of each of the ODT circuits 400a, 400b, 400c and 400d may be individually set based on respective position of each of the memory chips 200a, 200b, 200c and 200d in the multi-chip package 100a.

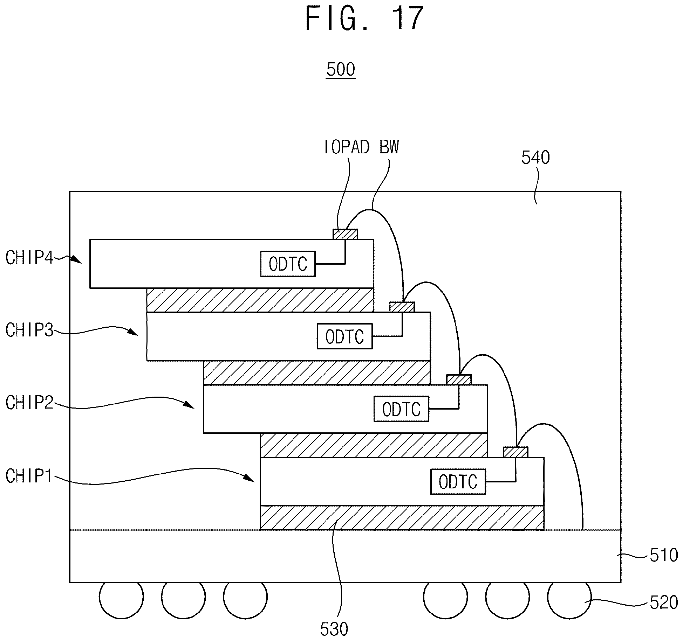

FIG. 17 is cross-sectional view of a memory package according to one or more embodiments.

Referring to FIG. 17, a memory package 500 includes a base substrate 510 and a plurality of memory chips CHIP1, CHIP2, CHIP3 and CHIP4 stacked on the base substrate 510.

Each of the memory chips CHIP1, CHIP2, CHIP3 and CHIP4 may include an ODT circuit ODTC and a plurality of I/O pads IOPAD. The ODT circuit ODTC may be connected to the I/O pads IOPAD.

Respective resistance values of each of the ODT circuits ODTCs may be individually set based on the respective position of each of the memory chips CHIP1, CHIP2, CHIP3 and CHIP4 in the memory package 500.

In one or more embodiments, the memory chips CHIP1, CHIP2, CHIP3 and CHIP4 may be stacked on the base substrate 510 such that a surface on which the plurality of I/O pads IOPAD are formed faces upwards. In one or more embodiments, with respect to each of the memory chips CHIP1, CHIP2, CHIP3 and CHIP4, the plurality of I/O pads IOPAD may be arranged near one side of the semiconductor substrate. As such, the memory chips CHIP1, CHIP2, CHIP3 and CHIP4 may be stacked scalariformly, that is, in a step shape, such that the plurality of I/O pads IOPAD of each memory chip may be exposed. In such stacked state, the memory chips CHIP1, CHIP2, CHIP3 and CHIP4 may be electrically connected to the base substrate 510 through a plurality of bonding wires BW.

The stacked memory chips CHIP1, CHIP2, CHIP3 and CHIP4 and the plurality of bonding wires BW may be fixed by a sealing member 540, and adhesive members 530 may intervene between the base substrate 510 and the memory chips CHIP1, CHIP2, CHIP3 and CHIP4. Conductive bumps 520 may be formed on a bottom surface of the base substrate 510 for electrical connections to an external device.

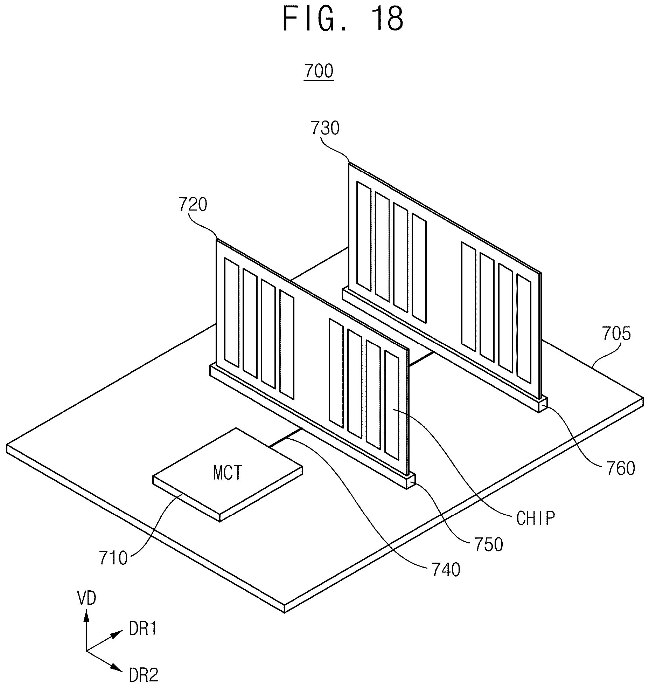

FIG. 18 is a schematic illustrating a memory system according to one or more embodiments.

Referring to FIG. 18, a memory system 700 may include sockets 750 and 760, a memory controller (MCT) 710 and a substrate 705.

The sockets 750 and 760 and the memory controller 710 may be attached on the substrate 705 and may be electrically connected to each other via an electric conductor included in the substrate 705. A first memory module 720 may be installed in the memory system 700 via the socket 750 and a second memory module 730 may be may be installed in the memory system 700 via the socket 760. Each of the sockets 750 and 760 may be referred to as a connector. For example, each of the first memory module 720 and the second memory module 730 is a Dual In-line Memory Module (DIMM).

The substrate 705 may extend in a first direction DR1 and a second direction DR2 crossing the first direction DR1. The substrate 705 may be referred to as a PCB. The first memory module 720 and the second memory module 730 may exchange signals with the memory controller 710 through a signal transmission line 740 extending in the first direction DR1.

A plurality of memory chips CHIP may be mounted (e.g., installed) in each of the first memory module 720 and the second memory module 730. Each of the plurality of memory chips CHIP may correspond to a memory chip described with reference to FIGS. 4 through 16 and may include an ODT circuit.

The first memory module 720 may be spaced apart from the memory controller 710 by a first distance in the first direction DR1, the second memory module 730 may be spaced apart from the memory controller 710 by a second distance in the first direction DR1. The second distance is different from the first distance. Because distances of the first memory module 720 and the second memory module 730 in the first direction DR1 from the memory controller are different, signal integrity of the signal transmission line 740 may be different with respect to the first memory module 720 and the second memory module 730. Therefore, a mode register in each of the memory chips CHIP mounted on the first memory module 720 and the second memory module 730 may differently set a respective resistance value of the ODT circuit based on the distance from the memory controller 710 in the first direction DR1.

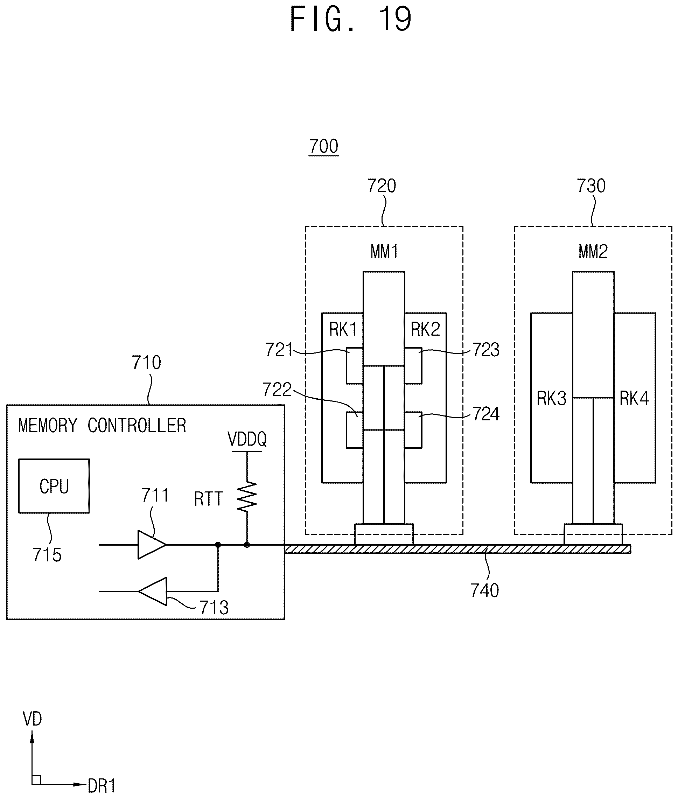

FIG. 19 is a block diagram illustrating a memory system of FIG. 18 according to one or more embodiments.

Referring to FIG. 19, the memory system 700 may include the memory controller 710, the first memory module MM1 720 and the second memory module MM2 730.

The memory controller 710 may control the first memory module 720 and the second memory module 730 so as to perform a command supplied from a processor and/or host. The memory controller 710 may be implemented using processing circuitry (e.g., a processor) and/or may be implemented with a host, an application processor or a system-on-a-chip (SoC). For signal integrity, a source termination may be implemented with a resistor RTT on a bus (or, a signal transmission line) 740 of the memory controller 710. The resistor RTT may be coupled to a power supply voltage VDDQ. The memory controller 710 may include a transmitter 711, which may transmit a signal to at least one of the first memory module 720 and the second memory module 730, and a receiver 713 that may receive a signal from at least one of the first memory module 720 and the second memory module 730. The memory controller 710 may include a CPU 715.

The first memory module 720 and the second memory module 730 may be coupled to the memory controller 710 through the bus 740. Each of the first memory module 720 and the second memory module 730 may include a plurality of memory chips and/or a registered clock driver. The first memory module 720 may include memory ranks RK1 and RK2, and the second memory module 730 may include memory ranks RK3 and RK4.

The memory rank RK1 may include memory chips 721 and 722 and the memory rank RK2 may include memory chips 723 and 724. Although not illustrated, each of the memory ranks RK3 and RK4 may include memory chips. Each of the memory chips 721, 722, 723 and 724 may employ the memory chip 200a of FIG. 4.

Each of the memory chips 721, 722, 723 and 724 may include an ODT circuit and each of the memory chips in the second memory module 730 may include ODT circuit.

Therefore, a mode register in each of the memory chips mounted on the first memory module 720 and the second memory module 730 may differently set a respective resistance value of the ODT circuit based on the distance from the memory controller 710 in the first direction DR1.

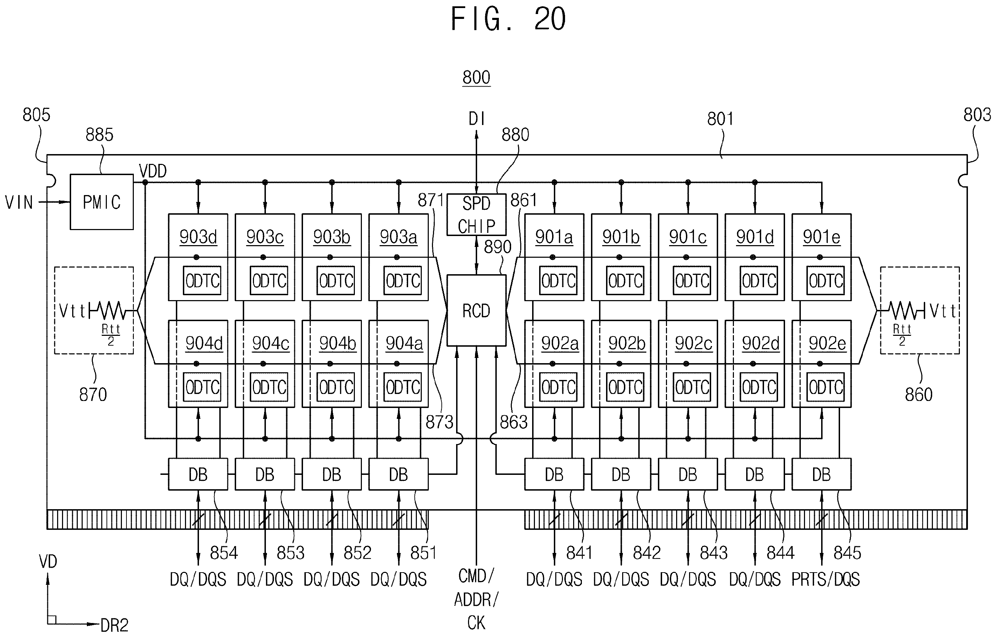

FIG. 20 is a block diagram illustrating a memory module that may be employed by a memory system according to one or more embodiments. The memory module may be a dual in-line memory module (DIMM).

Referring to FIG. 20, a memory module 800 may include a registered clock driver (RCD) 890 disposed in or mounted on a circuit board 801, a plurality of memory chips 901a-901e, 902a-902e, 903a-903d, and 904a-904d, a plurality of data buffers DBs 841-845 and 851-854, module resistor units 860 and 870, a serial present detect (SPD) chip 880, and a power management integrated circuit (PMIC) 885. Each of the plurality of memory chips 901a-901e, 902a-902e, 903a-903d, and 904a-904d may employ the memory chip 200a of FIG. 4 and may include an ODT circuit ODTC.

The RCD 890 may control the memory chips 901a-901e, 902a-902e, 903a-903d, and 904a-904d and the PMIC 885 under control of the memory controller 710. For example, the RCD 890 may receive an address ADDR, a command CMD, and a clock signal CK from the memory controller 710.

The SPD chip 880 may be a programmable read only memory (e.g., Electrically Erasable Programmable Read-Only Memory (EEPROM)). The SPD chip 880 may include initial information or device information DI of the memory module 800. In one or more embodiments, the SPD chip 880 may include the initial information or the device information DI such as a module form, a module configuration, a storage capacity, a module type, an execution environment, or the like of the memory module 800.

When a memory system including the memory module 800 is booted up, the memory controller 710 may read the device information DI from the SPD chip 880 and may recognize the memory module 800 based on the device information DI. The memory controller 710 may control the memory module 800 based on the device information DI from the SPD chip 880. For example, the memory controller 710 may recognize a type of the semiconductor memory devices included in the memory module 800 based on the device information DI from the SPD chip 880.

Here, the circuit board 801 which is a printed circuit board, may extend in the second direction DR2, perpendicular to the third direction VD, between a first edge portion 803 and a second edge portion 805. The first edge portion 803 and the second edge portion 805 may extend in the third direction VD.

The RCD 890 may be disposed on a center of the circuit board 801. The plurality of memory chips 901a-901e, 902a-902e, 903a-903d, and 904a-904d may be arranged in a plurality of rows between the RCD 890 and the first edge portion 803 and between the RCD 890 and the second edge portion 805.

In this case, the memory chips 901a-901e and 902a-902e may be arranged along a plurality of rows between the RCD 890 and the first edge portion 503. The memory chips 903a-903d, and 904a-904d may be arranged along a plurality of rows between the RCD 890 and the second edge portion 805. The memory chips 901a-901d, 902a-902d, 903a-903d, and 904a-904d may be referred to as data chips and the memory chips 901e and 902e may be referred to as first and second parity chips respectively.

Each of the plurality of memory chips 901a-901d, 902a-902d, 903a-903d, and 904a-904d may be coupled to a corresponding one of the data buffers 841-844 and 851-854 through a data transmission line for receiving/transmitting data signal DQ and data strobe signal DQS. Each of the memory chips 901e and 902e may be coupled to the data buffer 845 through a data transmission line for receiving/transmitting parity data PRTS and the data strobe signal DQS.

The RCD 890 may provide a command/address signal (e.g., CA) to the memory chips 901a-901e through a command/address transmission line 861 and may provide a command/address signal to the memory chips 902a-902e through a command/address transmission line 863.

In addition, the RCD 890 may provide a command/address signal to the memory chips 903a-903d through a command/address transmission line 871 and may provide a command/address signal to the memory chips 904a-904d through a command/address transmission line 873.

The command/address transmission lines 861 and 863 may be connected in common to the module resistor unit 860 disposed to be adjacent to the first edge portion 803, and the command/address transmission lines 871 and 873 may be connected in common to the module resistor unit 870 disposed to be adjacent to the second edge portion 805.

Each of the module resistor units 860 and 870 may include a termination resistor Rtt/2 connected to a termination voltage Vtt. In this case, an arrangement of the module resistor units 860 and 870 may reduce the number of the module resistor units, thus reducing an area where termination resistors are disposed.

The SPD chip 880 may be disposed to be adjacent to the RCD 890 and the PMIC 885 may be disposed between the memory chip 903d and the second edge portion 805. The PMIC 885 may generate a power supply voltage VDD based on an input voltage VIN and may provide the power supply voltage VDD to the plurality of memory chips 901a-901e, 902a-902e, 903a-903d, and 904a-904d.

Although it is illustrated that the PMIC 885 is disposed to be adjacent to the second edge portion 805 in FIG. 20, the PMIC 885 may be disposed elsewhere within the circuit board 801, such as in a central portion of the circuit board 801 to be adjacent to the RCD 890 in one or more embodiments.

The memory module 800 may correspond to at least one of the first memory module 720 and the second memory module 730 in FIG. 19.

Therefore, each of the plurality of memory chips 901a-901e, 902a-902e, 903a-903d, and 904a-904d may include a mode register and the mode register may enhance signal integrity by differently setting respective resistance value of the ODT circuit based on the distance from the memory controller 710 in the first direction DR1 and/or based on a distance of each of the plurality of memory chips 901a-901e, 902a-902e, 903a-903d, and 904a-904d in the circuit board 801. For instance, the resistance value for a memory chip in a memory module may be set based on the distance of the memory module from the memory controller 710 and/or based on the position of the memory chip within the memory module. For instance, the distance between the memory chip and the memory controller 710 may be based on the distance of the memory module from the memory controller 710 and the distance of the memory chip from an input/output (e.g., a socket) of the memory module. For instance, the distance between the memory chip and the memory controller 710 may be based on a distance in the first direction DR1 between the memory chip and the memory controller 710, and a distance in the third direction VD between a surface of the PCB 740 and the memory chip.

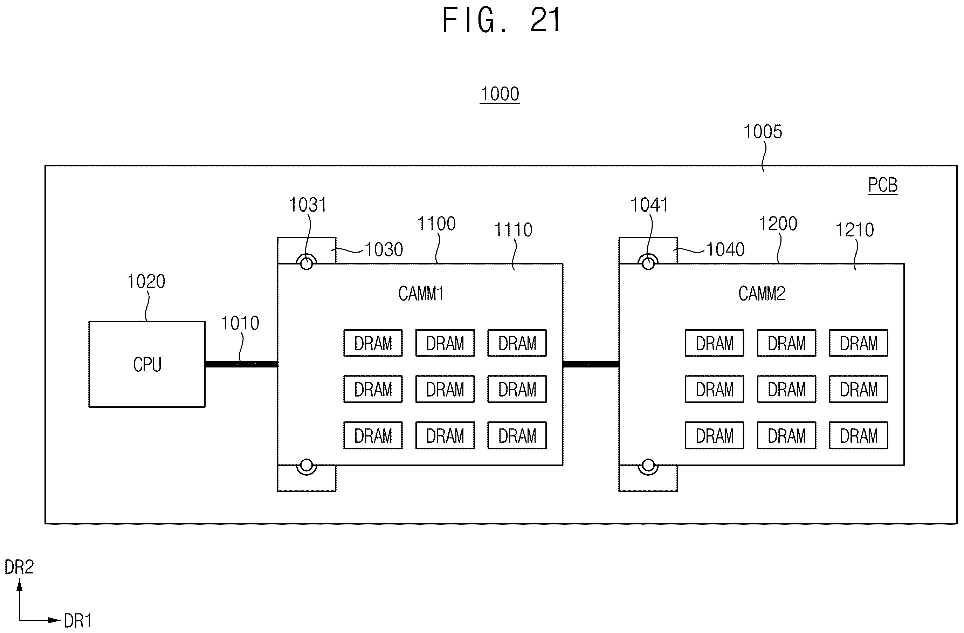

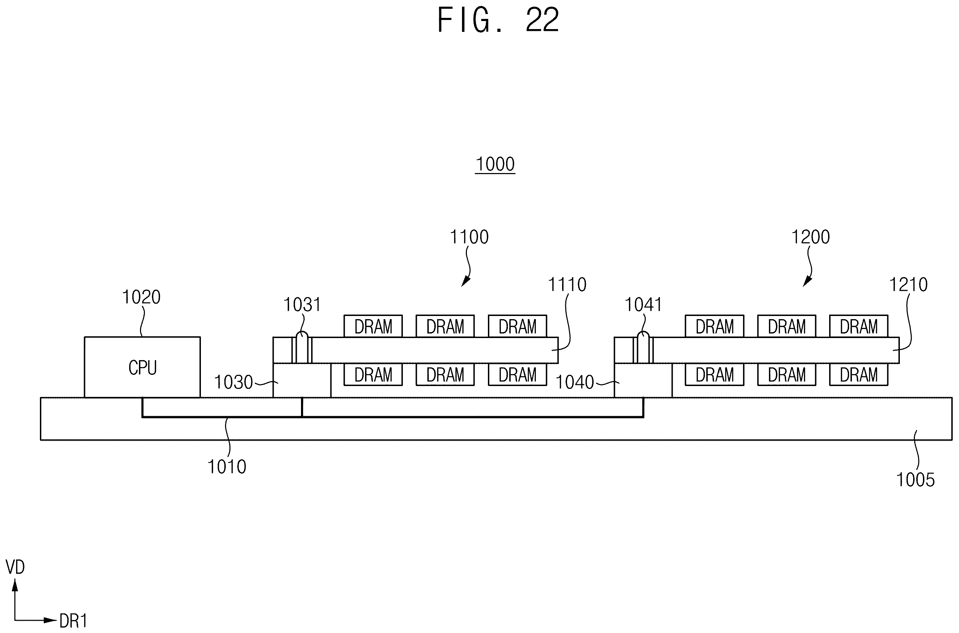

FIGS. 21 and 22 are block diagrams illustrating a memory system according to one or more embodiments.

Referring to FIGS. 21 and 22, a memory system 1000 may include a CPU 1020, a first compression attached memory module (CAMM) 1100, and a second CAMM 1200 which are mounted on a (printed) circuit board 1005. The first CAMM 1100 is denoted by CAMM1 and the second CAMM 1200 is denoted by CAMM2. The CPU 1020 may be included in the memory controller.

The first CAMM 1100 may include a first group of memory chips mounted on both surfaces of a first module board 1110 and the second CAMM 1200 may include a second group of memory chips mounted on both surfaces of a second module board 1210. For example, the first module board 1110 and the second module board 1120 may extend in the second direction DR2 and the third direction VD. In one example, the first CAMM 1100 can be replaced with a first dual in-line memory module (DIMM), and the second CAMM 1200 can be replaced with a second DIMM.

The first group of memory chips may be arranged in the first direction DR1 and the second direction DR2 on both surfaces of the first module board 1110 and the second group of memory chips may be arranged in the first direction DR1 and the second direction DR2 on both surfaces of the second module board 1210. Therefore, a thickness of the first CAMM 1100 and the second CAMM 1200 in the third direction VD may be reduced.

The first CAMM 1100 and the second CAMM 1200 may communicate with the CPU 1020 by sharing a signal transmission line 1010 and may be connected to the signal transmission line 1010 at different branch positions of the signal transmission line 1010.

Each of the first group of memory chips and the second group of memory chips may be a DRAM device.

Each of the first module board 1110 and the second module board 1210 may extend in the first direction DR1 and the second direction DR2 and may be spaced apart from the circuit board 1005 in the third direction VD.

The first module board 1110 may be installed in the circuit board 1005 via a first socket 1030, which is spaced apart from the CPU 1020 by a first distance in the first direction DR1, through a first connection member 1031 and the second module board 1210 may be installed in the circuit board 1005 via a second socket 1040, which is spaced apart from the CPU 1020 by a second distance in the first direction DR1, through a second connection member 1041. Each of the first socket 1030 and the second socket 1040 may be referred to as a socket. The first socket 1030 may extrude from a surface of the circuit board 1005 in the third direction VD and the second socket 1040 may extrude from the surface of the circuit board 1005 in the third direction VD.

Each of the first group of memory chips and the second group of memory chips may employ the memory chip 200a of FIG. 4. Therefore, each of the first group of memory chips and the second group of memory chips may include a mode register and an ODT circuit and the mode register may enhance signal integrity by differently setting respective resistance value of the ODT circuit based on the distance from the CPU 1020 in the first direction DR1 and/or based on a distance of each of the plurality of memory chips in each of the module boards 1110 and 1210. For instance, the resistance value for a memory chip in a group of memory chips may be set based on the distance of the group of memory chips from the memory controller 1020 and/or based on the position of the memory chip within the group of memory chips. For instance, the distance between the memory chip and the memory controller 1020 may be based on the distance of the group of memory chips from the memory controller 1020 and the distance of the memory chip from an input/output of the group of memory chips (e.g., a corresponding socket). For instance, the distance between the memory chip and the memory controller 1020 may be based on a distance in the first direction DR1 between the socket of the group of memory chips and the memory controller 1020, and a distance (e.g., in the first direction DR1) between the socket of the group of memory chips and the memory chip.

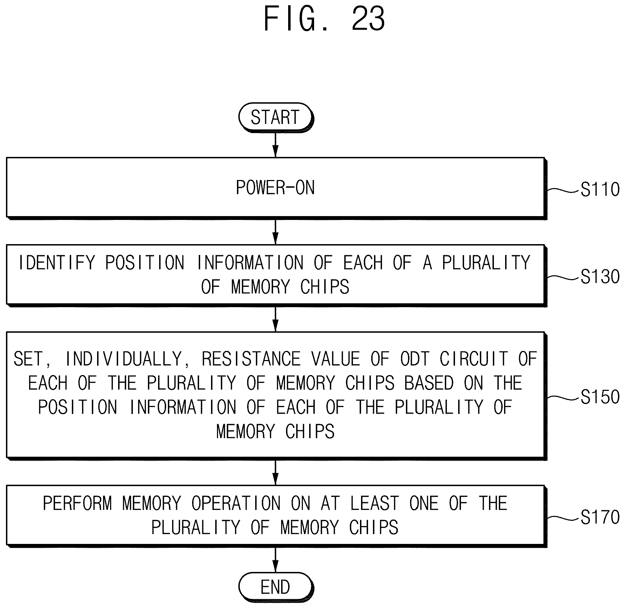

FIG. 23 is a flow chart illustrating a method of operating a multi-chip package according to one or more embodiments.

Referring to FIGS. 1 through 16 and 23, there is provided a method of operating a multi-chip package and the multi-chip package includes a PCB extending in a first direction and a second direction crossing the first direction and a plurality of memory chips stacked on the PCB in a third direction. Alternatively, referring to FIGS. 17 to 23, there is provided a method of operating a multi-chip package and the multi-chip package includes a first and second memory modules each comprising one or more respective memory chips, and wherein the first and second memory modules are located at different distances from a memory controller. The plurality of memory chips communicate with an external memory controller through a signal transmission line and share the signal transmission line. The third direction is perpendicular to the first direction and the second direction.

According to the method, the multi-chip package is powered-on (operation S110).

A mode register in each of the plurality of memory chips identifies respective position information of each of the plurality of memory chips (operation S130).

The mode register in each of the plurality of memory chips individually sets a resistance value of the respective one of a plurality ODT circuits based on a respective position information (operation S150). The position information may be associated with a surface of the PCB (e.g., may represent a distance of the memory cell from the surface of the PCB, e.g., in the third direction). In addition or alternatively, the position information may be associated with a distance (e.g., in the first direction) from the memory controller. Each of the plurality ODT circuits may be included in respective one of the plurality of memory chips.

The external memory controller performs a memory operation on at least one of the plurality of memory chips (operation S170).

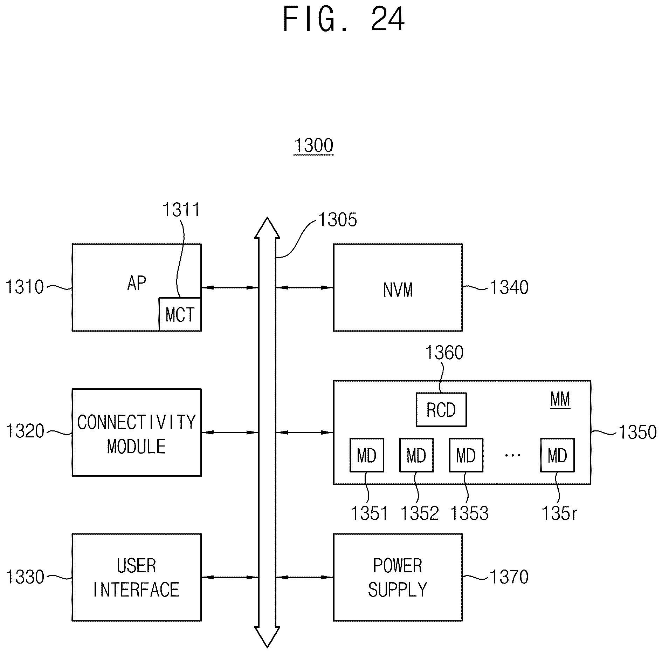

FIG. 24 is a block diagram illustrating a mobile system including a memory module according to one or more embodiments.

Referring to FIG. 24, a mobile system 1300 may include an application processor 1310, a connectivity module 1320, a memory module MM 1350, a nonvolatile memory device 1340, a user interface 1330, and a power supply 1370. The application processor 1310 may include a memory controller (MCT) 1311 (e.g., connected by a bus 1305).

The application processor 1310 may execute applications, such as a web browser, a game application, a video player, etc. The connectivity module 1320 may perform wired or wireless communication with an external device.

The memory module 1350 may store data processed by the application processor 1310 or operate as a working memory. The memory module 1350 may include a plurality of semiconductor memory devices MD 1351, 1352, 1353, ... , 135r (where r is a positive integer greater than three), and an RCD 1360.

Each of the semiconductor memory devices 1351, 1352, 1353, ... , 135r may be referred to as a memory chip and may employ the memory chip 200a of FIG. 4. Therefore, each of the semiconductor memory devices 1351, 1352, 1353, ... , 135r may include a mode register and an ODT circuit. The mode register may differently set resistance value of the respective ODT circuit based on a position of each of the semiconductor memory devices 1351, 1352, 1353, ... , 135r in the memory module 1350.

The nonvolatile memory device 1340 may store a boot image for booting the mobile system 1300. The user interface 1330 may include at least one input device, such as a keypad, a touch screen, etc., and at least one output device, such as a speaker, a display device, etc. The power supply 1370 may supply an operating voltage to the mobile system 1300.

The mobile system 1300 or components of the mobile system 1300 may be mounted using various types of packages.

At least one of the components, elements, modules, units, or the like (collectively "components" in this paragraph) represented by a block or an equivalent indication (collectively "block") in the above embodiments, including the drawings such as FIGS 1-4, 6, 8-10, 13, 14, and 20, and further including, for example, features such as a processor, a refresh management (RFM) control logic, a refresh logic, a host interface, a scheduler, a memory interface controller, a control logic circuit, an address register, a bank control logic, a refresh control circuit, a row address multiplexer, a column address latch, a row decoder, a column decoder, a sense amplifier unit, an input/output (I/O) gating circuit, an error correction code (ECC) engine, a clock buffer, a strobe signal generator, a data I/O buffer, flip-flop, latch, or the like, may carry out the above-described function or functions. These blocks may be physically implemented by analog and/or digital circuits such as logic gates, integrated circuits, microprocessors, microcontrollers, memory circuits, passive electronic components, active electronic components, optical components, hardwired circuits and the like, and may optionally be driven by a firmware. The circuits may, for example, be embodied in one or more semiconductor chips, or on substrate supports such as printed circuit boards and the like. The circuits constituting a block may be implemented by dedicated hardware, or by a processor (e.g., one or more programmed microprocessors and associated circuitry), or by a combination of dedicated hardware to perform some functions of the block and a processor to perform other functions of the block. Each block of the embodiments may be physically separated into two or more interacting and discrete blocks without departing from the scope of the disclosure. Likewise, the blocks of the embodiments may be physically combined into more complex blocks without departing from the scope of the disclosure.

Embodiments are set out in the following Clauses:
Clause 1. A multi-chip package comprising:
   a printed circuit board (PCB) extending in a first direction and a second direction, wherein the second direction crosses the first direction; and
   a plurality of memory chips stacked on the PCB in a third direction,
   wherein the plurality of memory chips are configured to communicate with an external memory controller through a signal transmission line and to share the signal transmission line,
   wherein the third direction is perpendicular to the first direction and the second direction,
   wherein each of the plurality of memory chips comprises a respective one of a plurality of on-die termination (ODT) circuits coupled to the signal transmission line, and
   wherein each of the plurality of memory chips is configured to individually set a resistance value of the respective one of the plurality of ODT circuits based on respective position information of the respective memory chip relative to a surface of the PCB.
Clause 2. The multi-chip package of Clause 1, wherein the respective position information is associated with a length of the signal transmission line through which each of the plurality of memory chips is connected to the external memory controller.
Clause 3. The multi-chip package of Clause 1 or Clause 2, wherein the signal transmission line comprises:
   a branch transmission line connected to each of the plurality of memory chips; and
   a main transmission line connecting the external memory controller and the branch transmission line.
Clause 4. The multi-chip package of any preceding Clause, wherein a first memory chip among the plurality of memory chips further comprises a first mode register configured to set a first resistance value of a first ODT circuit among the plurality of ODT circuits and to apply a first ODT control signal to the first ODT circuit based on first position information of the first memory chip relative to the surface of the PCB.
Clause 5. The multi-chip package of Clause 4, wherein each of the plurality of memory chips is selected based on a respective one of a plurality of chip selection signals, and
   wherein the first mode register is further configured to change the first resistance value of the first ODT circuit based on the first position information and based on whether the first memory chip is selected by a first chip selection signal among the plurality of chip selection signals.
Clause 6. The multi-chip package of Clause 4 or Clause 5, wherein the first memory chip further comprises a first fuse circuit storing the first position information, and
   wherein the first fuse circuit is configured to provide the first position information to the first mode register.
Clause 7. The multi-chip package of Clause 6, wherein the first position information is stored in the first fuse circuit as part of a fabrication of the multi-chip package.
Clause 8. The multi-chip package of Clause 6 or Clause 7, wherein the first fuse circuit is further configured to provide the first position information to the first mode register after the multi-chip package is powered-on.
Clause 9. The multi-chip package of Clause 4 or Clause 5, wherein the first memory chip further comprises a first connection circuit configured to indicate the first position information based on an internal bonding configuration of the first connection circuit, and
   wherein the first mode register is further configured to identify the first position information based on the internal bonding configuration of the first connection circuit.
Clause 10. The multi-chip package of any of Clauses 4-9, wherein the first ODT circuit comprises:
   a termination controller configured to generate a termination control signal based on the first ODT control signal; and
   a termination resistor circuit configured to provide the signal transmission line with the first resistance value as a termination resistance, based on the termination control signal.
Clause 11. The multi-chip package of Clause 10, wherein the termination controller comprises:
   a plurality of registers configured to store a plurality of control codes associated with potential resistance values of the first memory chip,
   a multiplexer connected to the plurality of registers, wherein the multiplexer is configured to select one of the plurality of control codes as a selected control code based on a selection signal in the termination control signal; and
   a termination control signal generator configured to generate the termination control signal based on the selected control code.
Clause 12. The multi-chip package of Clause 11, wherein each of the plurality of control codes corresponds to a selection state of each of the plurality of memory chips and a state of enablement of each of the plurality of ODT circuits.
Clause 13. The multi-chip package of any preceding Clause, wherein each of the plurality of memory chips further comprises:
   a memory cell array comprising a plurality of memory cells coupled to a plurality of word-lines and a plurality of bit-lines, wherein the memory cell array is configured to store data; and
   a data input/output buffer connected to the respective one of the plurality of ODT circuits, and
   wherein each of the plurality of memory cells comprises a cell transistor and a cell capacitor.
Clause 14. A memory system comprising:
   a multi-chip package; and
   a memory controller configured to control the multi-chip package through a signal transmission line,
   wherein the multi-chip package comprises:
      a printed circuit board (PCB) extending in a first direction and a second direction, wherein the second direction crosses the first direction; and
      a plurality of memory chips stacked on the PCB in a third direction,
   wherein the plurality of memory chips are configured to communicate with the memory controller through the signal transmission line and to share the signal transmission line,
   wherein the third direction is perpendicular to the first direction and the second direction,
   wherein each of the plurality of memory chips comprises a respective one of a plurality of on-die termination (ODT) circuits coupled to the signal transmission line, and
   wherein each of the plurality of memory chips is configured to individually set a resistance value of the respective one of the plurality of ODT circuits based on respective position information of the respective memory chip relative to a surface of the PCB.
Clause 15. The memory system of Clause 14,
   wherein the memory controller comprises a controller memory storing instructions,
   wherein the memory controller is configured to execute the instructions, and
   wherein the instructions, when executed by the memory controller, cause the memory controller to:
      read the respective position information from each of the plurality of memory chips during a power-up sequence; and
      control each of the plurality of memory chips to individually set the resistance value of the respective one of the plurality of ODT circuits based on the respective position information.
Clause 16. The memory system of Clause 14 or Clause 15, wherein each of the plurality of memory chips further comprises:
   a mode register configured to set the resistance value of the respective one of the plurality of ODT circuits; and
   a first fuse circuit in which the respective position information is stored.
Clause 17. A memory system comprising:
   a memory controller comprising a central processing unit (CPU), wherein the memory controller is mounted on a printed circuit board (PCB) extending in a first direction and a second direction crossing the first direction;
   a first memory module comprising a first group of memory chips, wherein the first memory module is mounted in a first socket on the PCB, the first socket being spaced apart from the memory controller by a first distance in the first direction; and
   a second memory module comprising a second group of memory chips, wherein the second memory module is mounted in a second socket on the PCB, the second socket being spaced apart from the memory controller by a second distance in the first direction,
   wherein a first memory chip among the first group of memory chips and a second memory chip among the second group of memory chips communicate with the memory controller through a signal transmission line and share the signal transmission line, and each of the first memory chip and the second memory chip comprises an on-die termination (ODT) circuit coupled to the signal transmission line,
   wherein the first memory chip is configured to set a resistance value of the ODT circuit of the first memory chip based on position information of the first memory chip associated with a distance of the first memory chip from the memory controller in the first direction, and
   wherein the second memory chip is configured to set a resistance value of the ODT circuit of the second memory chip based on position information of the second memory chip associated with a distance of the second memory chip from the memory controller in the first direction.
Clause 18. The memory system of Clause 17, wherein each of the first memory chip and the second memory chip further comprises a mode register configured to set the resistance value of the ODT circuit of the respective memory chip based on the respective position information.
Clause 19. The memory system of Clause 17 or Clause 18,
   wherein each of the first memory module and the second memory module is a dual in-line memory module (DIMM),
   wherein each of the first group of memory chips is mounted on a first module board extending in the second direction and a third direction,
   wherein each of the second group of memory chips is mounted on a second module board extending in the second direction and the third direction, and
   wherein the third direction is perpendicular to the first direction and the second direction.
Clause 20. The memory system of any of Clause 17 or Clause 18,
   wherein each of the first memory module and the second memory module is a compression attached memory module (CAMM),
   wherein each of the first group of memory chips is mounted on a first module board extending in the second direction and a third direction, the first module board being spaced apart from the PCB in the third direction,
   wherein each of the second group of memory chips is mounted on a second module board extending in the second direction and the third direction, the second module board being spaced apart from the PCB in the third direction, and
   wherein the third direction is perpendicular to the first direction and the second direction.

The foregoing is illustrative of one or more embodiments and is not to be construed as limiting thereof. Although a one or more embodiments have been described, those skilled in the art will readily appreciate that many modifications are possible in the one or more embodiments without materially departing from the novel teachings and advantages of the present disclosure. Accordingly, all such modifications are intended to be included within the scope of the present disclosure as defined in the claims.

## Claims

1. A multi-chip package comprising:
a printed circuit board, PCB, (20) extending in a first direction and a second direction, wherein the second direction crosses the first direction; and
a plurality of memory chips (200a-200k) stacked on the PCB (20) in a third direction,
wherein the plurality of memory chips (200a-200k) are configured to communicate with an external memory controller (30) through a signal transmission line (TL) and to share the signal transmission line (TL),
wherein the third direction is perpendicular to the first direction and the second direction,
wherein each of the plurality of memory chips (200a-200k) comprises a respective one of a plurality of on-die termination, ODT, circuits (400a-400k) coupled to the signal transmission line (TL), and
wherein each of the plurality of memory chips (200a-200k) is configured to individually set a resistance value of the respective one of the plurality of ODT circuits (400a-400k) based on respective position information of the respective memory chip relative to a surface of the PCB (20).

2. The multi-chip package of claim 1, wherein the respective position information is associated with a length of the signal transmission line (TL) through which each of the plurality of memory chips (200a-200k) is connected to the external memory controller (30), and
wherein the signal transmission line (TL) comprises:
a branch transmission line (70) connected to each of the plurality of memory chips (200a-200k); and
a main transmission line (60) connecting the external memory controller (30) and the branch transmission line (70).

3. The multi-chip package of claim 1 or claim 2, wherein a first memory chip (200a) among the plurality of memory chips (200a-200k) further comprises a first mode register (212) configured to set a first resistance value of a first ODT circuit (400a) among the plurality of ODT circuits (400a-400k) and to apply a first ODT control signal to the first ODT circuit (400a) based on first position information of the first memory chip (200a) relative to the surface of the PCB (20).

4. The multi-chip package of claim 3, wherein each of the plurality of memory chips (200a-200k) is configured to be selected based on a respective one of a plurality of chip selection signals, and
wherein the first mode register (212) is further configured to change the first resistance value of the first ODT circuit (400a) based on the first position information and based on whether the first memory chip (200a) is selected by a first chip selection signal among the plurality of chip selection signals.

5. The multi-chip package of claim 3 or claim 4, wherein the first memory chip (200a) further comprises a first fuse circuit (370) storing the first position information, and
wherein the first fuse circuit (370) is configured to provide the first position information to the first mode register (212).

6. The multi-chip package of claim 5, wherein the first position information is stored in the first fuse circuit (370) as part of a fabrication of the multi-chip package.

7. The multi-chip package of claim 5 or claim 6, wherein the first fuse circuit (370) is further configured to provide the first position information to the first mode register (212) after the multi-chip package is powered-on.

8. The multi-chip package of claim 3 or claim 4, wherein the first memory chip (200a) further comprises a first connection circuit (375) configured to indicate the first position information based on an internal bonding configuration of the first connection circuit (375), and
wherein the first mode register (212) is further configured to identify the first position information based on the internal bonding configuration of the first connection circuit (375).

9. The multi-chip package of any of claims 3-8, wherein the first ODT circuit (400a) comprises:
a termination controller (410a) configured to generate a termination control signal based on the first ODT control signal; and
a termination resistance circuit (450a) configured to provide the signal transmission line (TL) with the first resistance value as a termination resistance, based on the termination control signal.

10. The multi-chip package of claim 9, wherein the termination controller (410a) comprises:
a plurality of registers (411-414) configured to store a plurality of control codes associated with potential resistance values of the first memory chip (200a);
a multiplexer (MUX) connected to the plurality of registers (411-414), wherein the multiplexer (MUX) is configured to select one of the plurality of control codes as a selected control code based on a selection signal in the first ODT control signal; and
a termination control signal generator (430) configured to generate the termination control signal based on the selected control code, and
wherein each of the plurality of control codes corresponds to a selection state of each of the plurality of memory chips (200a-200k) and a state of enablement of each of the plurality of ODT circuits (400a-400k).

11. The multi-chip package of any preceding claim, wherein each of the plurality of memory chips (200a-200k) further comprises:
a memory cell array (310) comprising a plurality of memory cells coupled to a plurality of word-lines and a plurality of bit-lines, wherein the memory cell array is configured to store data; and
a data input/output buffer (320) connected to the respective one of the plurality of ODT circuits (400a-400k), and
wherein each of the plurality of memory cells comprises a cell transistor and a cell capacitor.

12. A memory system comprising:
a memory controller (710) comprising a central processing unit, CPU, (715, 1020) wherein the memory controller (710) is mounted on a printed circuit board, PCB, (705, 1005) extending in a first direction and a second direction crossing the first direction;
a first memory module (720, 1100) comprising a first group of memory chips, wherein the first memory module (720, 1100) is mounted in a first socket (750, 1030) on the PCB (705, 1005), the first socket being (750, 1030) spaced apart from the memory controller (710) by a first distance in the first direction; and
a second memory module (730, 1200) comprising a second group of memory chips, wherein the second memory module (730, 1200) is mounted in a second socket (760, 1040) on the PCB (705, 1005), the second socket (760, 1040) being spaced apart from the memory controller (710) by a second distance in the first direction,
wherein a first memory chip among the first group of memory chips and a second memory chip among the second group of memory chips communicate with the memory controller through a signal transmission line (740, 1010) and share the signal transmission line (740, 1010), and each of the first memory chip and the second memory chip comprises an on-die termination, ODT, circuit coupled to the signal transmission line (740, 1010),
wherein the first memory chip is configured to set a resistance value of the ODT circuit of the first memory chip based on position information of the first memory chip associated with a distance of the first memory chip from the memory controller (710) in the first direction, and
wherein the second memory chip is configured to set a resistance value of the ODT circuit of the second memory chip based on position information of the second memory chip associated with a distance of the second memory chip from the memory controller (710) in the first direction.

13. The memory system of claim 12, wherein each of the first memory chip and the second memory chip further comprises a mode register configured to set the resistance value of the ODT circuit of the respective memory chip based on the respective position information.

14. The memory system of claim 12 or claim 13,
wherein each of the first memory module (720) and the second memory module (730) is a dual in-line memory module,
wherein each of the first group of memory chips is mounted on a first module board extending in the second direction and a third direction,
wherein each of the second group of memory chips is mounted on a second module board extending in the second direction and the third direction, and
wherein the third direction is perpendicular to the first direction and the second direction.

15. The memory system of claim 12 or claim 13,
wherein each of the first memory module (1100) and the second memory module (1200) is a compression attached memory module,
wherein each of the first group of memory chips is mounted on a first module board (1110) extending in the second direction and a third direction, the first module board (1110) being spaced apart from the PCB (1005) in the third direction,
wherein each of the second group of memory chips is mounted on a second module board (1210) extending in the second direction and the third direction, the second module board (1210) being spaced apart from the PCB (1005) in the third direction, and
wherein the third direction is perpendicular to the first direction and the second direction.
